(19) Europäisches Patentamt
European Patent Office
Office européen des brevets

(11) EP 1 577 089 B1

(12) **EUROPEAN PATENT SPECIFICATION**

(45) Date of publication and mention of the grant of the patent:
**30.07.2008 Bulletin 2008/31**

(51) Int Cl.:
***B41C 1/10*** *(2006.01)* ***B41M 1/06*** *(2006.01)*

(21) Application number: **05005862.7**

(22) Date of filing: **17.03.2005**

(54) **Lithographic printing method**

Lithographisches Druckverfahren

Procédé d'impression lithographique

(84) Designated Contracting States:
**AT BE BG CH CY CZ DE DK EE ES FI FR GB GR HU IE IS IT LI LT LU MC NL PL PT RO SE SI SK TR**

(30) Priority: **17.03.2004 JP 2004075837**

(43) Date of publication of application:
**21.09.2005 Bulletin 2005/38**

(73) Proprietor: **FUJIFILM Corporation**
**Minato-ku**
**Tokyo (JP)**

(72) Inventor: **Sonokawa, Koji**
**c/o Fuji Photo Film Co., Ltd.**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 0 258 519**
**EP-A- 0 461 426**
**EP-A- 1 232 859**
**WO-A-03/103963**
**US-A- 5 907 997**
**US-A1- 2002 178 945**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### FIELD OF THE INVENTION

The present invention relates to a printing method for a lithographic printing plate precursor having an image recording layer removable by a printing ink, a fountain solution or both thereof

### BACKGROUND OF THE INVENTION

The lithographic printing is a method of alternatively supplying a fountain solution and an oily ink to the surface of a lithographic printing plate having a surface composed of a lipophilic image part and a hydrophilic non-image part, the hydrophilic non-image part working as a fountain solution-receiving part (ink non-receiving part) and the ink being received only in the lipophilic image part by utilizing the repellency between water and oil from each other, and then transferring the ink to a material on which an image is printed, such as paper, thereby performing printing.

For producing the lithographic printing plate, a lithographic printing plate precursor (PS plate) comprising a hydrophilic support having provided thereon a lipophilic photosensitive resin layer (image recording layer) has been heretofore widely used. Usually, a lithographic printing plate is obtained by a plate-making method where the lithographic printing plate precursor is exposed through an original image such as lith film and while leaving the image recording layer working out to the image part, the other unnecessary image recording layer is dissolved and removed with a developer such as alkaline aqueous solution or organic solvent to expose the hydrophilic support surface and thereby form the non-image part.

In the plate-making process using a conventional lithographic printing plate precursor, a step of dissolving and removing the unnecessary image recording layer with a developer or the like must be provided after exposure and as one problem to be solved, it is demanded to dispense with or simplify such an additive wet processing. In particular, the treatment of waste solutions discharged accompanying the wet processing is recently a great concern to the entire industry in view of consideration for global environment and the demand for solving the above-described problem is becoming stronger.

As one of simple plate-making methods to cope with such a requirement, a method called on-press development has been proposed, where an image recording layer of a lithographic printing plate precursor removable in a normal printing process is used and after exposure, the unnecessary image recording layer is removed on a printing press to obtain a lithographic printing plate.

Specifically, the on-press development method includes, for example, a method using a lithographic printing plate precursor having an image recording layer dissolvable or dispersible in a fountain solution, an ink solvent or an emulsion of fountain solution and ink, a method of mechanically removing the image recording layer by the contact with rollers or a blanket cylinder of a printing press, and a method of weakening the cohesion of the image recording layer or adhesion between the image recording layer and the support by the impregnation of a fountain solution, an ink solvent or the like and then mechanically removing the image recording layer by the contact with rollers or a blanket cylinder.

In the present invention, unless otherwise indicated, the "development processing step" indicates a step where, by using an apparatus (usually an automatic developing machine) except for a printing press, the unnecessary portion of the image recording layer is removed through contact with a liquid (usually an alkaline developer) to expose the hydrophilic support surface, and the "on-press development" indicates a method or step where, by using a printing press, the unnecessary portion of the image recording layer is removed through contact with a liquid (usually a printing ink and/or a fountain solution) to expose the hydrophilic support surface.

On the other hand, a digitization technique of electronically processing, storing and outputting image information by using a computer has been recently widespread and various new image-output systems coping with such a digitization technique have been put into practical use. Along with this, a computer-to-plate (CTP) technique is attracting attention, where digitized image information is carried on a highly converging radiant ray such as laser light and a lithographic printing plate precursor is scan-exposed by the light to directly produce a lithographic printing plate with no intervention of a lith film. Accordingly, one of important technical problems to be solved is to obtain a lithographic printing plate precursor suitable for such a technique.

As described above, the demand for a simplified, dry-system and non-processing plate-making work is ever-stronger in recent years from both aspects of consideration for global environment and adaptation for digitization.

To satisfy this requirement, for example, Patent Document 1 describes a lithographic printing plate precursor where an image forming layer comprising a hydrophilic binder having dispersed therein hydrophobic thermoplastic polymer particles is provided on a hydrophilic support. In Patent Document 1, it is stated that the lithographic printing plate precursor, after exposed by an infrared laser to cause coalescence of the hydrophobic thermoplastic polymer particles due to heat and thereby form an image and then loaded on a cylinder of a printing press, can be on-press developed by supplying a fountain solution and/or ink.

However, in such a method of forming an image through coalescence by mere heat fusion of fine particles, despite good on-press developability, the image strength is extremely low and the press life is not satisfied.

For solving these problems, a technique of improving the press life by utilizing a polymerization reaction has been proposed. For example, Patent Document 2 describes a lithographic printing plate precursor comprising a hydrophilic support having thereon an image recording layer (thermosensitive layer) containing a polymerizable compound-enclosing microcapsule, and Patent Document 3 describes a lithographic printing plate precursor comprising a support having provided thereon an image recording layer (photosensitive layer) containing an infrared absorbent, a radical polymerization initiator and a polymerizable compound.

Also, Patent Document 4 describes a photosensitive lithographic printing plate having a photosensitive layer in a two-layer structure comprising a photosensitive hydrophilic layer and a photosensitive hydrophobic layer formed thereon. The photosensitive lithographic printing plate can be loaded on a printing press immediately after exposure without passing through any processing, then on-press developed and used for printing.

Furthermore, Patent Document 5 describes a photosensitive lithographic printing plate in a one-layer structure, comprising a photoinitiator and a polymer having a photocurable group and an acidic group or a salt thereof, which can be loaded on a printing press immediately after exposure without passing through any processing, then on-press developed and used for printing.

In addition, Patent Document 6 describes a method of imagewise exposing and then on-press developing a web-like image forming material wrapped around a plate cylinder, where single fluid ink is used without using a fountain solution.

[Patent Document 1] Japanese Patent No. 2,938,397

[Patent Document 2] JP-A-2001-277740 (the term "JP-A" as used herein means an "unexamined published Japanese patent application")

[Patent Document 3] JP-A-2002-29162

[Patent Document 4] WO 93/05446

[Patent Document 5] WO 96/34316

[Patent Document 6] JP-A-2002-321331

## SUMMARY OF THE INVENTION

However, the on-press development of the lithographic printing plate precursors has a problem that the on-press development proceeds at a low rate or proceeds non-uniformly within the plate surface. An object of the present invention is to solve the problem and provide a method for on-press developing a lithographic printing plate precursor, which can ensure rapid development and excellent uniformity of development within the plate surface. Another object of the present invention is to provide a method for on-press developing a lithographic printing plate precursor by radiating infrared light or light at 250 to 420 nm, which can ensure rapid development and excellent uniformity of development within the plate surface.

As a result of intensive studies, the present inventor has found that the above-described objects can be attained by using a keyless inking system (keyless inker) or single fluid ink. The present invention provides the followings.

1. A lithographic printing method comprising the following steps (i) to (v):

   (i) a step of preparing a lithographic printing plate precursor comprising a support having thereon an image recording layer removable by a printing ink, a fountain solution or both thereof,
   (iia) a step of loading the lithographic printing plate precursor on a plate cylinder of a printing press after imagewise exposing it, or (iib) a step of imagewise exposing the lithographic printing plate precursor after loading it on a plate cylinder of a printing press,
   (iii) a step of supplying ink to the lithographic printing plate precursor after exposure by a keyless inker,
   (iv) a step of removing the image recording layer of the lithographic printing plate precursor in the unexposed part after the completion of the step (iii) or simultaneously with the step (iii), and
   (v) a step of performing printing.

2. The lithographic printing method as described in 1 above, which further comprises, in any one of the steps (iii) to (v), a step of supplying a fountain solution to the lithographic printing plate precursor after exposure.
3. The lithographic printing method as described in 1 or 2 above, wherein the ink supplied to the lithographic printing plate precursor after exposure in the step (iii) is single fluid ink.
4. The lithographic printing method as described in any one of 1 to 3 above, wherein the image recording layer contains (A) an infrared absorbent, (B) a polymerization initiator and (C) a polymerizable compound, and a light source for the imagewise exposure is an infrared laser.

5. The lithographic printing method as described in any one of 1 to 3 above, wherein the image recording layer contains (B) a polymerization initiator and (C) a polymerizable compound and is sensitive to light of a wavelength of 250 to 420 nm, and a light source for the imagewise exposure is an ultraviolet laser.
6. A lithographic printing method comprising the following steps (i) to (v):

(i) a step of preparing a lithographic printing plate precursor comprising a support having thereon an image recording layer capable of being removed by a printing ink, a fountain solution or both thereof and forming an image by polymerization of a polymerizable compound,
(iia) a step of loading the lithographic printing plate precursor on a plate cylinder of a printing press after imagewise exposing it, or (iib) a step of imagewise exposing the lithographic printing plate precursor after loading it on a plate cylinder of a printing press,
(iii) a step of supplying to the lithographic printing plate precursor after exposure, a single fluid ink comprising an emulsion comprising a hydrophilic component comprising water and/or a polyhydric alcohol and an oily ink component using a keyless inker,
(iv) a step of removing the image recording layer of the lithographic printing plate precursor in the unexposed part after the completion of the step (iii) or simultaneously with the step (iii), and
(v) a step of performing printing.

7. The lithographic printing method as described in 6 above, wherein in the single fluid ink supplied to the lithographic printing plate precursor after exposure in the step (iii), a ratio between the oily ink component and the hydrophilic component is such that the hydrophilic component is from 5 to 150 parts by weight per 100 parts by weight of the oily ink component.
8. The lithographic printing method as described in 6 or 7 above, wherein the image recording layer contains (A) an infrared absorbent, (B) a polymerization initiator and (C) a polymerizable compound, and an exposure light source is an infrared laser.
9. The lithographic printing method as described in 6 or 7 above, wherein the image recording layer contains (B) a polymerization initiator and (C) a polymerizable compound and is sensitive to light at a wavelength of 250 to 420 nm, and an exposure light source is an ultraviolet laser.

BRIEF DESCRIPTION OF THE DRAWINGS

Fig. 1 is a schematic view of a printing apparatus with a keyless inker described in JP-A-2003-225991.
Fig. 2 (A) is a schematic view of an ink metering and supplying part of the keyless inker shown in Fig. 1.
Fig. 2 (B) and Fig. 2(C) are schematic views of other examples of the ink metering and supplying part used in the keyless inker, respectively.

10: Inker (ink supplying device)
12: Ink metering and supplying part
14: Ink draw roller (ink supply roller)
16: Ink applying roller
18: Rotation control part
20: Printing apparatus
22: Plate cylinder
24: Rubber cylinder
26: Impression cylinder
28: Emulsion disrupting means
32: Blade
34, 36: Adjusting roller

DETAILED DESCRIPTION OF THE INVENTION

The present invention is based on the finding that when a lithographic printing plate precursor is on-press developed by supplying a printing ink, the developability thereof is greatly affected by the amount of the ink supplied. More specifically, in the case of a conventional inker, the ink is intermittently supplied from an ink transfer roller to an ink kneading roller and in order to obtain a proper printed matter free from density unevenness or the like, a proper ink thin film having a thickness on the order of several μm must be stably formed on the surface of the ink applying roller

and this requires many ink kneading rollers as well as an ink key for adjusting the amount of the ink supplied, that is, the opening of the ink fountain, every each region finely divided to correspond to the area of the image part on the lithographic printing plate. Usually, the opening is adjusted to supply a large amount of ink for the region having a large image part area but is narrowed down for the region having a small image part area. However, the lithographic printing plate precursor according to the present invention at this time is being on-press developed by utilizing the tack of the ink and therefore, if the amount of the ink on the ink applying roller is small, the image recording layer in the unexposed part of the lithographic printing plate precursor cannot be satisfactorily removed or the on-press development proceeds at a low rate and development failure may occur in some cases. Accordingly, the development delays in the region where the image part area of the lithographic printing plate precursor is small, particularly, in both side portions of the lithographic printing plate precursor loaded on the plate cylinder, where an image is usually not formed.

On the contrary, when a keyless inker is used, it is considered that the amount of the ink on the ink applying roller can be easily made uniform in the entire width and the on-press development can be performed by a uniform force over the entire region within the surface of the lithographic printing plate precursor, as a result, uniform on-press developability within the plate surface can be assured and rapid on-press development can be achieved.

In the case of using a lithographic printing plate precursor capable of forming an image by polymerization of a polymerizable compound used in the present invention, the on-press developability, particularly, uniform on-press developability within the surface of the lithographic printing plate precursor can be improved by using single fluid ink without using the keyless inker as described above. The reason for this is considered that in the lithographic printing plate precursor capable of forming an image by polymerization of a polymerizable compound used in the present invention, development proceeds in such a manner that water or an aqueous component penetrates from the surface of the lithographic printing plate precursor into an image recording layer to reach the interface between the image recording layer and a substrate at the on-press development and due to tackiness of the ink component, the unexposed part of the image recording layer is removed by peeling-off, and as a result, the use of single fluid ink that can be supplied on the surface of the lithographic printing plate precursor simultaneously in the form of an emulsion of the aqueous component and an oily ink component more increases the on-press development speed. On the contrary, in the lithographic printing plate precursor forming an image by heat fusion of thermoplastic fine particles disclosed in JP-A-2002-321331, the above-described effects due to the use of single fluid ink are not recognized because the on-press development of the lithographic printing plate precursor proceeds only by dispersing the fine particles into the aqueous component.

According to the present invention, an on-press developing method capable of realizing rapid on-press development of a lithographic printing plate precursor and ensuring excellent uniformity of the development within the plate surface can be provided.

The lithographic printing method of the present invention and the lithographic printing plate precursor used therefor are described in detail below.

[Lithographic Printing Method]

The lithographic printing method according to one embodiment of the present invention comprises the following steps (i) to (v):

(i) a step of preparing a lithographic printing plate precursor comprising a support having thereon an image recording layer removable by a printing ink, a fountain solution or both thereof,
(iia) a step of loading the lithographic printing plate precursor on a plate cylinder of a printing press after imagewise exposing it, or (iib) a step of imagewise exposing the lithographic printing plate precursor after loading it on a plate cylinder of a printing press,
(iii) a step of supplying ink to the lithographic printing plate precursor after exposure by using a keyless inker,
(iv) a step of removing the image recording layer of the lithographic printing plate precursor in the unexposed part after the completion of the step (iii) or simultaneously with the step (iii), and
(v) a step of performing printing.

In particular, this embodiment of the present invention is characterized by the step (iii) of supplying ink by using as an ink-supplying device, a keyless inker. By this use, rapid on-press development and excellent uniformity within the plate surface can be obtained. The ink-supplying apparatus is described below.

In the printing apparatus where ink is supplied, the ink supplying device (hereinafter referred to as an "inker") of supplying ink to a printing plate wrapped around a plate cylinder ordinarily comprises supply means composed of an ink fountain and an ink draw roller, an ink transfer roller, an ink kneading roller (an ink kneading roller group), an ink applying roller and the like. In such an inker, the ink draw roller draws out ink from the ink fountain and transfers it to the ink transfer roller, the ink transfer roller transfers the ink to the ink kneading roller, the ink kneading roller transfers the kneaded ink to the ink applying roller, and the ink applying roller supplies the ink to the printing plate wrapped around

a plate cylinder.

The keyless inker for use in the present invention is an inker where as described, for example, in JP-A-58-45955, JP-A-58-65663, JP-A-58-84771, JP-A-61-280938, JP-A-63-162244 and JP-A-2003-225991, the ink is continuously supplied from the ink fountain, and the ink kneading roller is eliminated or greatly simplified by providing means for controlling and making uniform the thickness of ink thin film to the ink draw roller or ink applying roller.

The ink supplying method and keyless inker which are suitably used in the present invention are described in more detail by referring to the examples shown in the accompanying drawings.

Fig. 1 is a schematic view showing one example of the keyless inker for use in the present invention. The inker 10 shown in Fig. 1 fundamentally comprises an ink metering and supplying part 12 having an ink draw roller 14; an ink applying roller 16; and a rotation control part 18 of controlling the rotation of the ink draw roller 14 and the ink applying roller 16. Such an inker 10 is loaded on a printing apparatus 20 using single fluid ink, and the single fluid ink in the ink fountain shown by the halftone dot in the figure is drawn out by the ink draw roller 14, transferred to the ink applying roller 16 and then transferred from the ink applying roller 16 to a printing plate wrapped around a plate cylinder 22, whereby ink in a predetermined film thickness is supplied to the printing plate.

In the printing apparatus 20, similarly to a conventional printing apparatus, the ink applied to the printing plate wrapped around the plate cylinder 22 is transferred to a rubber cylinder (blanket cylinder) 24 and then transferred to a printing material P such as paper delivered while being impressed to the rubber cylinder 24 by an impression cylinder 26 and held between these cylinders, thereby performing the printing. In the example shown, for the sake of simplified description, the inker 10 for use in the present invention is applied to a monochromatic printing apparatus 20 but by employing a known constitution, the inker for use in the present invention can be of course applied to a printing apparatus of performing two or more multicolor printing.

The keyless inker for use in the present invention is not limited to those of supplying single fluid ink to the printing plate as in the example shown, but a keyless inker of supplying ink for conventional printing using a fountain solution can be also suitably used. However, in the case where conventional printing using a fountain solution is performed by using an inker relatively small in the number of rollers like the inker 10 shown, a phenomenon that the fountain solution is mixed in the ink fountain due to backflow of the overemulsified ink and the ink cannot be property supplied to the ink applying roller readily occurs. In order to avoid this phenomenon, the fountain solution device must be precisely adjusted, but the stable region thereof is vary narrow and the adjustment sometimes results in fail. For overcoming this problem, a method of using single fluid ink and eliminating the use of a fountain solution is effective. In such a case, the method described in JP-A-2003-225991 may be used, where ink applying rollers small in the difference of surface roughness or having a low surface roughness are used and the difference in the peripheral velocity between the ink applying roller and the roller of supplying ink to the ink applying roller is adjusted. When the method is used, the ink can be stably supplied with higher controllability even if the number of rollers is small.

In the present invention, the ink supply roller (roller of supplying ink to the ink applying roller) is preferably an ink draw roller of drawing out ink from the ink fountain, more preferably a roller having ink metering and supplying means for forming an ink layer having a constant film thickness on the surface of the ink draw roller. Also, in the present invention, the ink is preferably single fluid ink, the inker preferably has emulsion disrupting means of disrupting the single fluid ink emulsion adhering to the ink applying roller, and the emulsion disrupting means preferably has an adjusting mechanism of adjusting the degree of emulsion disruption. The emulsion disrupting means having the adjusting mechanism is preferably constituted to have a roller abutting against the ink applying roller and means for adjusting the abutting pressure of the roller, or is preferably a roller abutting the ink applying roller and variable in the direction and speed of rotation. Furthermore, in the present invention, the inker preferably has ink agitating means of agitating ink in the ink fountain, and the ink applying roller and the plate cylinder preferably have an approximately same diameter.

The ink metering and supplying part 12 is fundamentally a known ink fountain (ink reservoir) comprising an ink draw roller 14, a blade 32 (see, Fig. 2(A)) and the like, and the ink draw roller 14 draws out ink in a constant film thickness from the ink fountain (that is, meters and then draws out ink) and transfers the ink to the ink applying roller 16 rotating in contact with the ink draw roller 14. That is, in the inker 10 shown, the ink draw roller 14 of drawing out ink from the ink fountain is a roller abutting against the ink applying roller 16 and transferring the ink thereto, and serves also as an ink supply roller.

In the example shown, as seen in Fig. 2(A), the ink metering and supplying part 12 controls the film thickness (supply amount) of ink drawn out by the ink draw roller 14 by controlling the distance c between the end of the blade 32 and the ink draw roller 14. However, the ink metering and supplying means (metering means) is not limited to the example shown using an ink draw roller 14 and a blade 32, and various means can be employed as long as the difference in the peripheral velocity between the ink draw roller 14 and the ink applying roller 16 can be adjusted.

For example, ink metering and supplying means using an anilox roller and a doctor blade may be used, where the anilox roller draws out ink and the doctor blade scrapes off unnecessary ink, thereby supplying a predetermined amount of ink. Also, as shown in Fig. 2(B), metering means using an adjusting roller 34 disposed with a space from the ink draw roller 14 and capable of adjusting the distance c therebetween and the rotation speed may be employed, where

ink in a constant film thickness is drawn out by adjusting the distance c between these two rollers and the rotation speed of the adjusting roller 34. Furthermore, as shown in Fig. 2(C), metering means using an adjusting roller 36 disposed to abut against the ink draw roller 14 and capable of adjusting the abutting pressure (nip pressure) and rotation speed may also be employed, where ink in a constant film thickness is drawn out by adjusting the abutting pressure and the rotation speed of the adjusting roller 36.

In the case of the inker 10 of continuously supplying ink as in the example shown, the rotation speed of the ink draw roller 14 is relatively high and therefore, an aggregate of ink (so-called "ink roll") extending to the axis line direction of the ink draw roller 14 is sometimes produced in the ink fountain. The ink roll inhibits the flow of ink in the ink fountain and thereby interferes with the supply of ink in a constant amount. Particularly, in the case of the system using single fluid ink as in the example shown, when the ink roll is formed, the balance between the ink component and the aqueous component in the ink drawn out by the ink draw roller is changed and this causes adverse effects on the printing performance.

In order to prevent such troubles, the inker for use in the present invention preferably has ink agitating means of agitating ink in the ink fountain. Various ink agitating means can be used. Specific preferred examples thereof include an agitating roller rotating on a shaft parallel to the ink draw roller 14, and a baffle plate, which are each disposed in the ink fountain within the region of the formation of ink roll.

The agitating roller is preferably disposed at a distance of 0 to 5 mm from the ink draw roller 14. The baffle plate may take various shapes such as plate, prism and cylinder and in order to improve the agitation efficiency, it may comprise a plurality of stages along the rotation direction of the ink draw roller 16 or may be divided in the direction of the rotation axis of the ink draw roller 14 and disposed at different positions in the rotation direction.

The ink applying roller 16 is a roller of transferring ink transferred from the ink draw roller 14, to the printing plate wrapped around the plate cylinder. In order to prevent occurrence of ghost, the diameter of the ink applying roller 16 is preferably set to be nearly the same as the diameter of the plate cylinder 22.

As described above, the ink supplied from the inker 10 is preferably single fluid ink. The single fluid ink is obtained by dispersing and emulsifying an ink component and a water component and therefore, if applied as it is, the ink component and the water component may not be separated on the printing plate surface to fail in properly adhere to the image part and the non-image part. Therefore, in the example shown, as a preferred embodiment, the inker has emulsion disrupting means 28 of disrupting the ink emulsion held on the ink applying roller and separating the ink component and the water component.

The emulsion disrupting means 28 is not particularly limited and various methods can be employed. Examples thereof include means of giving a shear force to the ink adhering to the ink applying roller 16 and disrupting the emulsion. A suitable example of such emulsion disrupting means include a roller abutting against the ink applying roller 16 and rotating in the driven or opposite direction. Furthermore, in order to facilitate the emulsion disruption, as described, for example, in JP-A-53-36308, cooling means may be used in combination with the means of imparting the shear force, or cooling means alone may be used as the emulsion disrupting means.

The amount of the ink component transferred to the printing plate varies of course according to the image printed and in turn, the proportion of the water component in the emulsion adhering to the ink applying roller 16 or the like fluctuates, as a result, proper printing may not be performed. ,also, since a difference in the peripheral velocity may be present between the ink applying roller 16 and the ink draw roller 14, emulsion disruption is generated between these rollers. Moreover, when the difference in the peripheral velocity is changed, the degree of emulsion disruption fluctuates accordingly, as a result, the amount of the water component supplied to the printing plate is changed and similarly to the above, proper printing may not be performed. Therefore, in the inker 10, the emulsion disrupting means 28 preferably has controlling means of controlling the degree of emulsion disruption so as to supply the water content in a proper amount to the printing plate.

As for such controlling means, for example, in the case where the emulsion disrupting means 28 used is a roller abutting against the ink applying roller 16, suitable examples thereof include controlling means of controlling the direction and speed of rotation of the roller, and controlling means of controlling the abutting pressure (nip pressure) of the roller. The degree of the emulsion disruption may be adjusted, for example, by measuring the amount of the water content on the non-image part of the printing plate and controlling the rotation speed, abutting pressure or the like according to the amount measured.

The rotation controlling part 18 is a section of controlling the rotation speeds of the ink applying roller 16 and the ink draw roller 14 and gives a desired difference in the peripheral velocity between these rollers fundamentally by setting the rotation speed (peripheral velocity) of the ink applying roller 16 to a predetermined speed according to the printing speed and adjusting the rotation speed of the ink draw roller 14. As described above, by adjusting the difference in the peripheral velocity between the ink applying roller 16 and the ink draw roller (ink supply roller of transferring ink to the ink applying roller 16 by abutting thereto), the amount of the ink transferred to the ink applying roller 16 (thickness of ink thin film = printing density) can also be adjusted. As for the difference in the peripheral velocity, the ink applying roller 16 side takes the high-speed rotation part or the ink draw roller 14 side takes the high-seed rotation part.

By using such a keyless inker for use in the present invention, the on-press developability (easiness of on-press development by the rotation of printing press) of the lithographic printing plate precursor used in the present invention can be made uniform within the plane of the lithographic printing plate precursor.

The ink supplying method and ink supplying device for use in the present invention are described in detail, but the present invention is not limited to these embodiments and various changes and modifications can be within the scope defined by the appended claims.

For example, although in the inker 10 shown in Fig. 1, the ink draw roller 14 of drawing out ink from the ink fountain is an ink supply roller as a preferred embodiment of bringing out the characteristics of the present invention and achieving more simplification of the device, the present invention is not limited thereto and the inker may have one or more ink kneading rollers between the ink draw roller and the ink applying roller.

A lithographic printing method not according to the present invention comprises the following steps (i) to (v):

(i) a step of preparing a lithographic printing plate precursor comprising a support having thereon an image recording layer capable of being removed by a printing ink, a fountain solution or both thereof and forming an image by polymerization of a polymerizable compound,
(iia) a step of loading the lithographic printing plate precursor on a plate cylinder of a printing press after imagewise exposing it, or (iib) a step of imagewise exposing the lithographic printing plate precursor after loading it on a plate cylinder of a printing press,
(iii) a step of supplying to the lithographic printing plate precursor after exposure, a single fluid ink comprising an emulsion comprising a hydrophilic component comprising water and/or a polyhydric alcohol and an oily ink component,
(iv) a step of removing the image recording layer of the lithographic printing plate precursor in the unexposed part after the completion of the step (iii) or simultaneously with the step (iii), and
(v) a step of performing printing.

Accordingly, single fluid ink is used and therefore, even when a conventional inker but not a keyless inker is used as the inking system, the lithographic printing plate precursor, which forms an image by utilizing the polymerization of a polymerizable compound, can be enhanced in its on-press developability, particularly, uniformity of on-press developability within the surface of the lithographic printing plate precursor.

The single fluid ink for use in the present invention is described in detail below.

The single fluid ink for use in the present invention is not particularly limited and various types can be used. Specifically, preferred examples thereof include single fluid inks disclosed in JP-B-49-26844 (the term "JP-B" as used herein means an "examined Japanese patent publication"), JP-B-49-27124, JP-B-49-27125, JP-B-61-52867, JP-A-53-27803, JP-A-53-29807, JP-A-53-36307, JP-A-53-36308, JP-A-54-106305, JP-A-54-146110, JP-A-57-212274, JP-A-58-37069 and JP-A-58-211484.

The single fluid ink for use in the present invention comprises an emulsion that comprises a hydrophilic component and an oily ink component. The emulsion may be either a W/O (water-in-oil) type or an O/W (oil-in-water) type. The single fluid ink is prepared according to conventional manner, for example, by adding a hydrophilic component to an oily ink component and emulsifying these components. The single fluid ink for use in the present invention keeps a stable emulsified state during storage in an ink can or in an ink fountain of a printing press when applied to printing. At the printing, when the single fluid ink reaches the ink applying roller after transit through the inking system (ink supply system) under sharing, the emulsification is disrupted and the hydrophilic component is separated and supplied to the plate surface. On the plate surface, the hydrophilic component attaches to the non-image region and forms a liquid film to prevent attachment of the oily ink component and in the meanwhile, the oily ink component attaches to the image region. As long as these functions are satisfied, the single fluid ink is not particularly limited and any single fluid ink can be used in the present invention. Also, for facilitating expression of the above-described functions by the single fluid ink for use in the present invention, it is more preferred to use a printing press having an inking system with a cooling mechanism.

The ratio between the oily ink component and the hydrophilic component in the single fluid ink for use in the present invention is preferably such that the hydrophilic component is from 5 to 150 parts by weight, more preferably from 10 to 120 parts by weight, still more preferably from 20 to 100 parts by weight, per 100 parts by weight of the oily ink component. As for the oily ink component in the single fluid ink for use in the present invention, a conventional oily ink comprising a vegetable oil, a synthetic or natural resin varnish or their synthetic varnish, a high boiling point petroleum solvent, a pigment and other additives (e.g., abrasion resistance enhancer, ink dryer, drying inhibitor) can be used.

As for the hydrophilic component in the single fluid ink for use in the present invention, water and/or polyhydric alcohols can be used. Examples of the polyhydric alcohols include glycerin, diglycerin, ethylene glycol, diethylene glycol, propylene glycol, dipropylene glycol, hexylene glycol sorbitol, butanediol and pentanediol. Among these, glycerin, ethylene glycol, diethylene glycol, propylene glycol and dipropylene glycol are preferred. The polyhydric alcohols may be

used individually or in combination of two or more thereof or may be used as a mixture with water. In the present invention, the content of polyhydric alcohol in the hydrophilic component is preferably from 30 to 100 wt%, more preferably from 50 to 100 wt%. In the hydrophilic component for use in the present invention, other than those described above, additives may be used for the purpose of, for example, enhancing the emulsion stability, improving the flow property, elevating the hydrophilicity or suppressing the evaporation of the hydrophilic component. Examples thereof include monohydric alcohols such as methanol and ethanol, amino alcohols such as monoethanolamine and diethanolamine, known nonionic, anionic, cationic or betaine surfactants, oxycarboxylic acids such as glycolic acid, lactic acid and citric acid, hydrophilic polymers such as polyvinylpyrrolidone, polyacrylic acid, gum arabic and carboxymethyl cellulose, and inorganic acids or salts thereof such as phosphoric acid, silicic acid, nitric acid and salts thereof

In the present invention, the lithographic printing plate precursor prepared in the step (i) is imagewise exposed in the step (iia) or (iib). The imagewise exposure is performed by the exposure through a transparent original having a line image, a halftone image or the like, or by the scan-exposure with a laser based on digital data. Examples of the light source suitable for the exposure include a carbon arc lamp, a mercury lamp, a xenon lamp, a metal halide lamp, a strobe, an ultraviolet ray, an infrared ray and a laser beam. In particular, a laser beam is preferred and, for example, a solid or semiconductor laser of emitting infrared ray of 760 to 1,200 nm, and a semiconductor laser of emitting light of 250 to 420 nm may be used.

In the present invention, a fountain solution can be supplied to the exposed lithographic printing plate precursor in any one step of (iii) to (iv). As for the fountain solution, a fountain solution for conventional lithographic printing is used.

In the present invention, the steps (iii) and (iv), the steps (iv) and (v), or the steps from (iii) to (v) may be a continuous and unified step.

Thus, the lithographic printing plate precursor is on-press developed on an offset printing press and used as it is for printing a large number of sheets.

[Lithographic Printing Plate Precursor]

The lithographic printing plate precursor for use in the present invention comprises a support having thereon an image recording layer removable by a printing ink, a fountain solution or both thereof. The image recording layer is preferably an image recording layer containing (A) an infrared absorbent, (B) a polymerization initiator or (C) a polymerizable compound and capable of recording an image by an infrared laser, or an image recording layer containing (B) a polymerization initiator and (C) a polymerizable compound and being sensitive to light of 250 to 420 nm.

These constituent components of the lithographic printing plate precursor are described below.

<(A) Infrared Absorbent>

The infrared absorbent for use in the present invention has a function of converting the absorbed infrared ray into heat. Due to the heat generated, a polymerization initiator (radical generator) described later is thermally decomposed and generates a radical. The infrared absorbent for use in the present invention is a dye or pigment having an absorption maximum in a wavelength range of 760 to 1,200 nm.

As for the dye, commercially available dyes and known dyes described in publications, for example, Senryo Binran (Handbook of Dyes), compiled by Yuki Gosei Kagaku Kyokai (1970), may be used. Specific examples thereof include dyes such as azo dye, metal complex azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Other preferred examples of the infrared absorbing dye for use in the present invention include specific indolenine cyanine dyes described in JP-A-2002-278057, such as those set forth below.

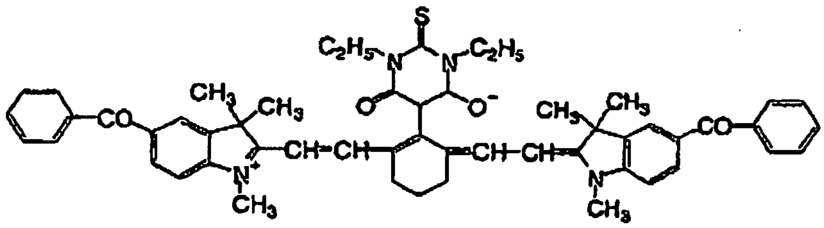

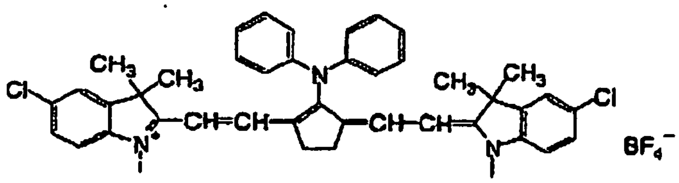

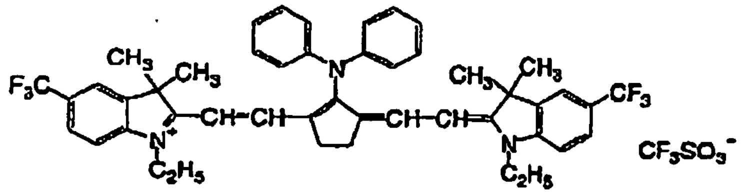

Among these dyes, particularly preferred are cyanine dye, squarylium dye, pyrylium salt, nickel thiolate complex and indolenine cyanine dye, and more preferred are cyanine dye and indolenine cyanine dye. One example of particularly preferred dyes includes a cyanine dye represented by the following formula (I):

(I)

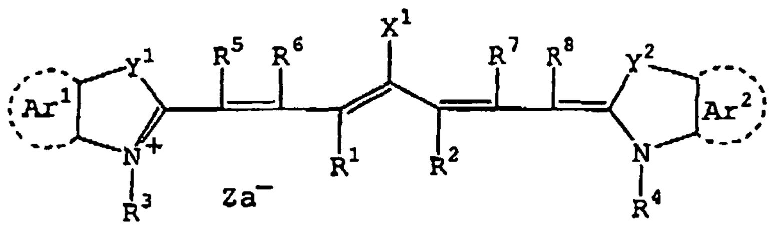

In formula (I), $X^1$ represents a hydrogen atom, a halogen atom, $-NPh_2$, $X^2$-$L^1$ or a group shown below:

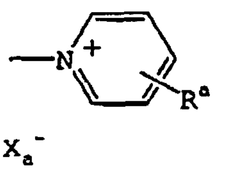

(wherein $X^2$ represents an oxygen atom, a nitrogen atom or a sulfur atom, $L^1$ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), $X_a^-$ has the same definition as $Za^-$ described later, and $R^a$ represents a hydrogen atom, an alkyl group, an aryl group, a substituted or unsubstituted amino group or a halogen atom).

$R^1$ and $R^2$ each independently represents a hydrocarbon group having from 1 to 12 carbon atoms. In view of

storage stability of the coating solution for the recording layer, $R^1$ and $R^2$ each is preferably a hydrocarbon group having 2 to more carbon atoms, and $R^1$ and $R^2$ are more preferably combined with each other to form a 5- or 6-membered ring.

$Ar^1$ and $Ar^2$ may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. $Y^1$ and $Y^2$ may be the same or different and each represents a sulfur atom or a dialkylmethylene group having 12 or less carbon atoms. $R^3$ and $R^4$ may be the same or different and each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$ may be the same or different and each represents a hydrogen atom or a hydrocarbon group having 12 or less carbon atoms, and in view of availability of the raw material, preferably a hydrogen atom. $Za^-$ represents a counter anion, but when the cyanine dye represented by formula (I) has an anionic substituent in its structure and neutralization of electric charge is not necessary, $Za^-$ is not present. In view of storage stability of the coating solution for the recording layer, $Za^-$ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (I), which can be suitably used in the present invention, include those described in paragraphs [0017] to [0019] of JP-A-2001-133969.

Other particularly preferred examples include specific indolenine cyanine dyes described in JP-A-2002-278057.

As for the pigment used in the present invention, commercially available pigments and pigments described in Color Index (C.I.), Saishin Ganryo Binran (Handbook of Newest Pigments), compiled by Nippon Ganryo Gijutsu Kyokai (1977), Saishin Ganryo Oyo Gijutsu (Newest Pigment Application Technology), CMC Shuppan (1986), and Insatsu Ink Gijutsu (Printing Ink Technology), CMC Shuppan (1984) can be used.

The kind of pigment includes black pigment, yellow pigment, orange pigment, brown pigment, red pigment, violet pigment, blue pigment, green pigment, fluorescent pigment, metal powder pigment and polymer bond pigment. Specific examples of the pigment which can be used include insoluble azo pigments, azo lake pigments, condensed azo pigments, chelate azo pigments, phthalocyanine-based pigments, anthraquinone-based pigments, perylene- and perynone-based pigments, thioindigo-based pigments, quinacridone-based pigments, dioxazine-based pigments, isoindolinone-based pigments, quinophthalone-based pigments, dyed lake pigments, azine pigments, nitroso pigments, nitro pigments, natural pigments, fluorescent pigments, inorganic pigments and carbon black. Among the pigments, carbon black is preferred.

The pigments may or may not be surface-treated before use. Examples of the method for surface treatment include a method of coating the surface with resin or wax, a method of attaching a surfactant, and a method of bonding a reactive substance (for example, silane coupling agent, epoxy compound or isocyanate) to the pigment surface. The surface-treatment methods are described in Kinzoku Sekken no Seishitsu to Oyo (Properties and Application of Metal Soap), Saiwai Shobo, Insatsu Ink Gijutsu (Printing Ink Technology), CMC Shuppan (1984), and Saishin Gamyo Oyo Gijutsu (Newest Figment Application Technology), CMC Shuppan (1986).

The particle diameter of the pigment is preferably from 0.01 to 10 $\mu$m, more preferably from 0.05 to 1 $\mu$m, still more preferably from 0.1 to 1 $\mu$m. Within the range, good stability of the pigment dispersion in the coating solution for the image recording layer and good uniformity of the image recording layer can be obtained.

For dispersing the pigment, a known dispersion technique used in the production of ink or toner may be used. Examples of dispersing machine include ultrasonic disperser, sand mill, attritor, pearl mill, super-mill, ball mill, impeller, disperser, KD mill, colloid mill, dynatron, three-roll mill and pressure kneader. These are described in detail in Saishin Ganryo Oyo Gijutsu (Newest Pigment Application Technology), CMC Shuppan (1986).

The infrared absorbent may be added together with other components in the same layer or may be added to a layer provided separately, but the infrared absorbent is added such that when a lithographic printing plate precursor is produced, the absorbancy of the image recording layer at a maximum absorption wavelength in the wavelength range of 760 to 1,200 nm is from 0.3 to 1.2, more preferably from 0.4 to 1.1, as measured by a reflection measuring method. Within the range, a uniform polymerization reaction proceeds in the depth direction of the image recording layer, and the image part can have good film strength and good adhesion to the support.

The absorbancy of the image recording layer can be adjusted by the amount of the infrared absorbent added to the image recording layer and the thickness of the image recording layer. The absorbancy can be measured by an ordinary method. Examples of the measuring method include a method where an image recording layer having a thickness appropriately decided in the range of the dry coated amount necessary as a lithographic printing plate is formed on a reflective support such as aluminum and the reflection density is measured by an optical densitometer, and a method of measuring the absorbancy by a spectrophotometer according to a reflection method using an integrating sphere.

<(B) Polymerization Initiator>

The polymerization initiator for use in the present invention is a compound of generating a radical by the effect of light or heat energy and thereby initiating or accelerating the polymerization of a compound having a polymerizable unsaturated group. Such a radical generator may be appropriately selected and used from known polymerization initiators, compounds having a bond small in the bond-dissociation energy, and the like.

Examples of the compound of generating a radical include organohalogen compounds, carbonyl compounds, organic peroxides, azo-based polymerization initiators, azide compounds, metallocene compounds, hexaarylbiimidazole compounds, organic boron compounds, disulfone compounds, oxime ester compounds and onium salt compounds.

Specific examples of the organohalogen compound include the compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, M.P. Hutt, Journal of Heterocyclic Chemistry, 1, No. 3 (1970). In particular, oxazole compounds and s-triazine compounds each substituted with a trihalomethyl group are preferred.

Furthermore, s-triazine derivatives having at least one mono-, di- or tri-halogenated methyl group bonded to the s-triazine ring are more preferred and specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triaine, 2-(p-tolyl)-4,6-bis(trichloromethyl)-s-triaine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below..

(I)-1

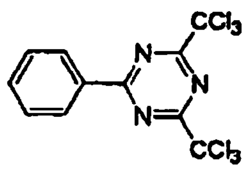

(I)-2

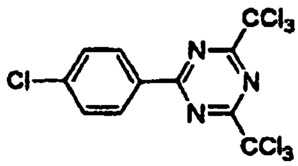

(I)-3

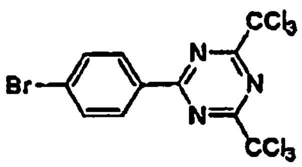

(I)-4

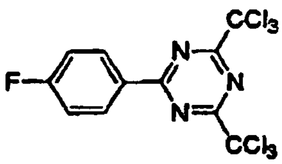

(I)-5

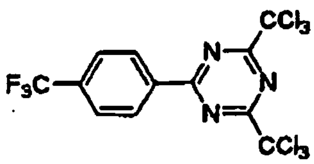

(I)-6

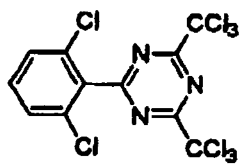

(I)-7

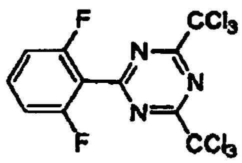

(I)-8

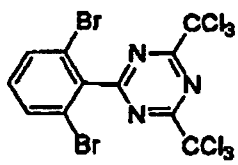

(I)-9

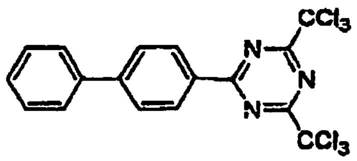

(I)-10

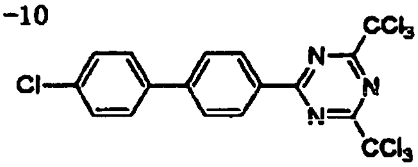

(I)-11

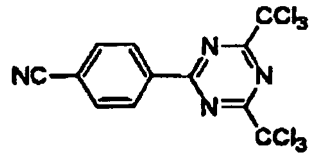

(I)-12

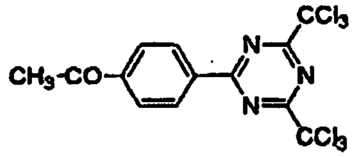

(I)-13

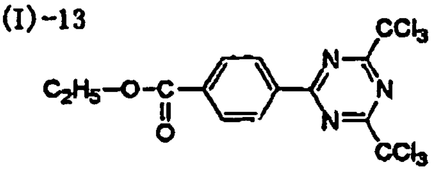

(I)-14

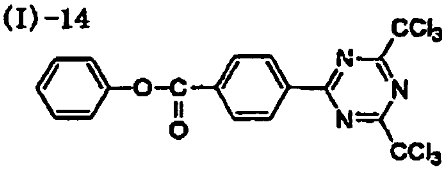

(I)-15

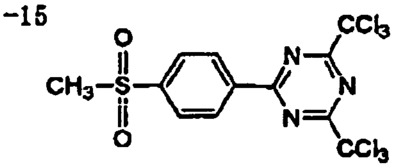

(I)-16

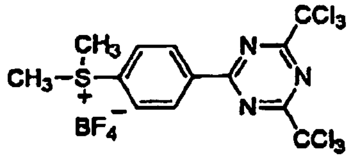

(I)-17

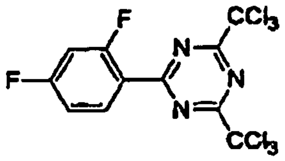

(I)-18

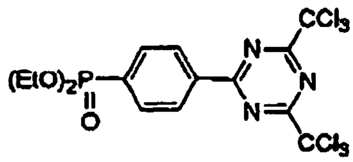

(I)-19

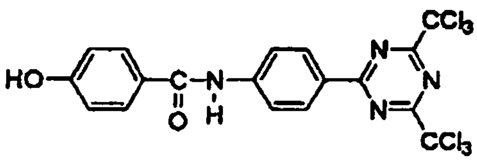

(I)-20

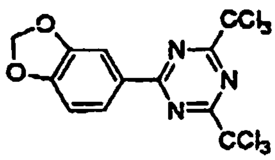

(I)-21

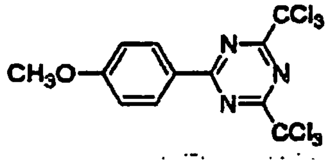

(I)-22

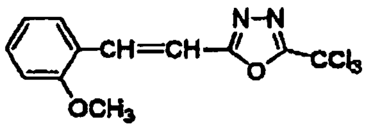

(I)-23

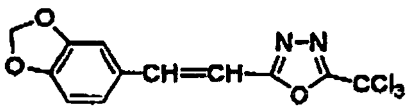

(I)-24

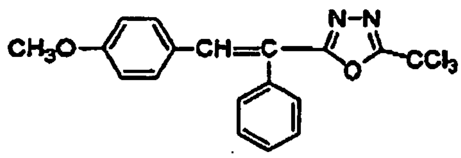

(I)-25

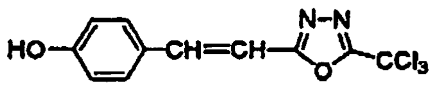

(I)-26

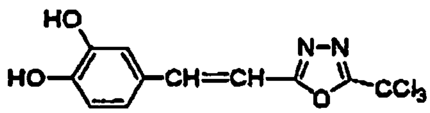

(I)-27

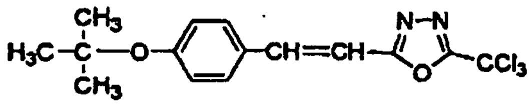

Examples of the carbonyl compound include benzophenone derivatives such as benzophenone, Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylawophenone, 2,2-diethoxyacetophenone, 1-hydroxycyclohexylphenylketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxantone derivatives such as thioxantone, 2-ethylthioxanthone, 2-isopropylthioxanthone, 2-chlorothioxanthone, 2,4-dimethylthioxanthone, 2,4-diethylthioxanthone and 2,4-diisopropylthioxanthone; benzoic acid ester derivatives such as ethyl p-dimethylaminobenzoate and ethyl p-diethylaminobenzoate.

Examples of the azo-based compound which can be used include azo compounds described in JP-A-8-108621.

Examples of the organic peroxide include trimethylcyclohexanone peroxide, acetylacetone peroxide, 1,1-bis (tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di (tert-butylperoxy)hexane, 2,5-oxanoyl peroxide, succinic peroxide, benzoyl peroxide, 2,4-dichlorobenzoyl peroxide, diisopropylperoxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butylperoxyacetate, tert-butylperoxypivalate, tert-butylperoxyneodecanoate, tert-butylperoxyoctanoate, tert-butylperoxylaurate, tert-carbonate, 3,3',4,4'-tetra(tert-butylperoxycarbanyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogendiphthalate) and carbonyl di(tert-hexylperoxydihydrogendiphthalate).

Examples of the metallocene compound include various titanocene compounds described in JP-A-59-152396, JP-A-61-151197, JP-A-63-41484, JP-A-2-249, JP-A-2-4705 and TP-A-5-83588, such as dicyclopentadienyl-Ti-bis-phenyl, dir-yclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadieriyl-Ti-bis-2,3,5,6-teLrafluorophen-1-yl and dimethylcyclopentadienyl-Ti-bis-2,3,4,5,6-pentafluorophen-1-yl, and iron-allene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o',dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of the organic boron compound include organic borates described in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Martin Kunz, Rad Tech. '98. Proceeding April 19-22, 1998, Chicago; organic boron sulfonium complexes and organic boron oxosulfonium complexes described in JP-A-6-157623, JP-A-6-175564 and JP-A-6-175561; organic boron iodonium complexes described in JP-A-6-175554 and JP-A-6-175553; organic boron phosphonium complexes described in JP-A-9-188710; and organic boron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin Π, 1653-1660 (1979), J.C.S. Perkin II, 156-162 (1979), Journal of Photopolymer Science and Technology, 202-232 (1995), JP-A-2000-66385 and JP-A-2000-80068. Specific examples thereof include the compounds represented by the following structural formulae.

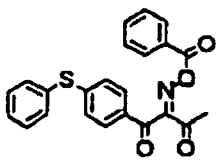 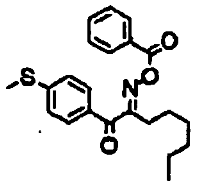 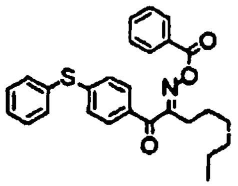 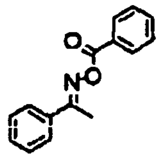 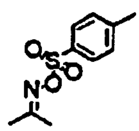

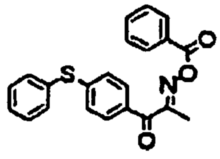 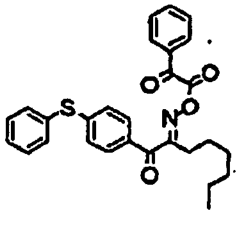 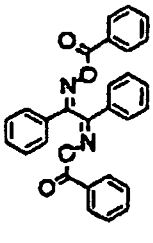 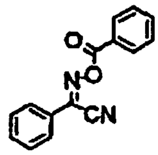 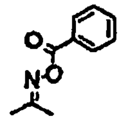

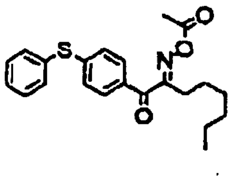 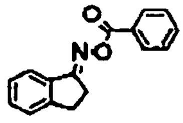 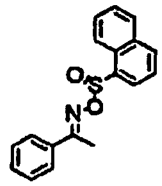 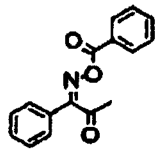 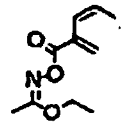

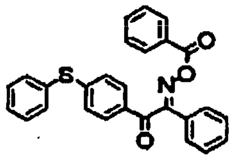 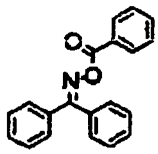 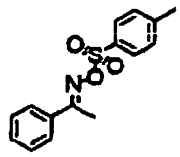 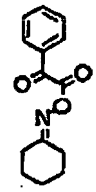 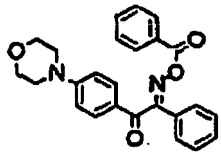

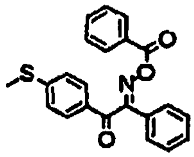 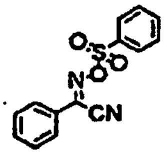

Examples of the onium salt compound include onium salts such as diazonium salts described in S.I. Schlesinger, Photogr. Sci. Eng. 18, 387 (1974) and T.S. Bal et al., Polymer, 21, 423 (1980); ammonium salts described in U.S. Patent 4,069,055 and JP-A-4-365049; phosphonium salts described in U.S. Patents 4,069,055 and 4,069,056; iodonium salts described in European Patent 104,143, U.S. Patents 339,049 and 410,201, JP-A-2-150848 and JP-A-2-296514; sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581; selenonium salts described in J.V. Crivello et al., Macromolecules, 10 (6), 1307 (1977) and J.V. Crivello et al., J Polymer Sci., Polymer Chem. Ed., 17, 1047 (1979); and arsonium salts described in C.S. Wen et al., Teh. Proc Coni Rad. Curing ASIA, p. 478, Tokyo, Oct. (1988).

In the present invention, the onium salt acts as an ionic radical polymerization initiator but not as an acid generator.

The onium salt preferably used in the present invention is an onium salt represented by any one of the following formulae (RI-I) to (RI-III):

$$Ar_{11}-\overset{+}{N}\equiv N \qquad Z_{11}^{-} \qquad \text{(RI-I)}$$

$$Ar_{21}-\overset{+}{I}-Ar_{22} \qquad Z_{21}^{-} \qquad \text{(RI-II)}$$

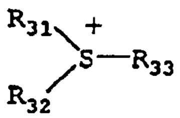 $Z_{31}^{-}$ (RI-III)

In formula (RI-I), $Ar_{11}$ represents an aryl group having 20 or less carbon atoms, which may have from 1 to 6 substituent(s), and preferred examples of the substituent include an alkyl group having from 1 to 12 carbon atoms, an alkenyl group having from 2 to 12 carbon atoms, an alkynyl group having from 2 to 12 carbon atoms, an aryl group

having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 1 to 12 carbon atoms, an alkylamide or arylamide group having from 1 to 12 carbon atoms, a carbonyl group, a carboxyl group, a cyano group, a sulfonyl group, a thioalkyl group having from 1 to 12 carbon atoms, and a thioaryl group having from 6 to 12 carbon atoms. $Z_{11}^-$ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability are perchlorate ion, hexafluorophosphate ion, tetrafluoroborate ion, sulfonate ion and sulfinate ion.

In formula (RI-II), $Ar_{21}$ and $Ar_{22}$ each independently represents an aryl group having 20 or less carbon atoms, which may have from 1 to 6 substituent(s), and preferred examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 1 to 12 carbon atoms, an alkylamide or arylamide group having from 1 to 12 carbon atoms, a carbonyl group, a carboxyl group, a cyano group, a sulfonyl group, a thioalkyl group having from 1 to 12 carbon atoms, and a thioaryl group having from 6 to 12 carbon atoms. $Z_{21}^-$ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability and reactivity are perchlorate ion, hexafluorophosphate ion, tetrafluoroborate ion, sulfonate ion, sulfinate ion and carboxylate ion.

In formula (RI-III), $R_{31}$, $R_{32}$ and $R_{33}$ each independently represents an aryl, alkyl, alkenyl or alkynyl group having 20 or less carbon atoms, which may have from I to 6 substituent(s), and in view of reactivity and stability, preferably an aryl group. Examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 1 to 12 carbon atoms, an alkylamide or arylamide group having from 1 to 12 carbon atoms, a carbonyl group, a carboxyl group, a cyano group, a sulfonyl group, a thioalkyl group having from 1 to 12 carbon atoms, and a thioaryl group having from 6 to 12 carbon atoms. $Z_{31}^-$ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Particularly, in view of stability and reactivity, perchlorate ion, hexafluorophosphate ion, tetrafluoroborate ion, sulfonate ion, sulfinate ion and carboxylate ion are preferred, carboxylate ion described in JP-A-2001-343742 is more preferred, carboxylate ion described in JP-A-2002-148790 is still more preferred.

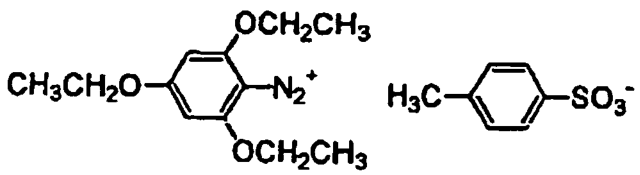

(N-1)

$PF_6^-$ (N-2)

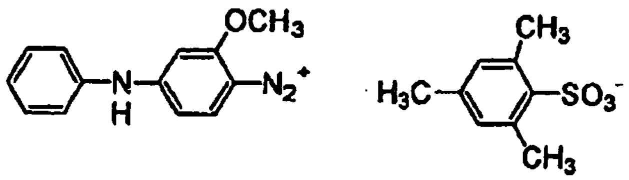

(N-3)

$ClO_4^-$ (N-4)

$PF_6^-$ (N-5)

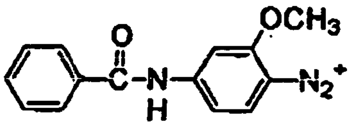

$CF_3SO_3^-$ (N-6)

$BF_4$ (N-7)

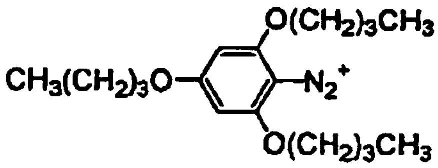

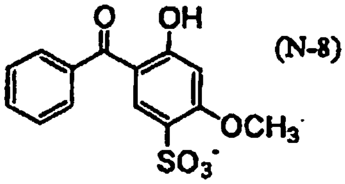

(N-8)

$ClO_4^-$ (N-7)

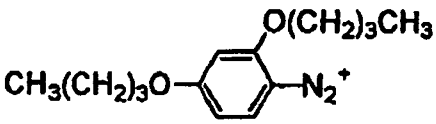

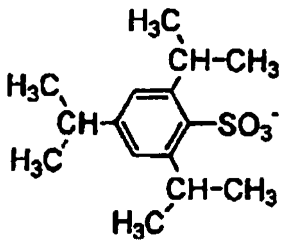

(N-10)

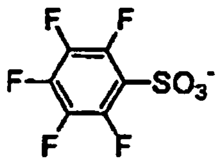

(N-11)

$PF_6^-$ (N-12)

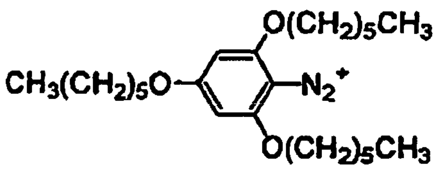

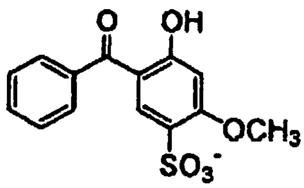

(N-13)

$ClO_4^-$ (N-14)

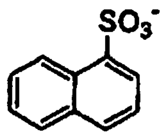

(N-15)

$PF_6^-$ (N-16)

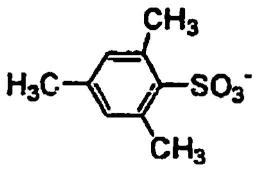

(N-17)

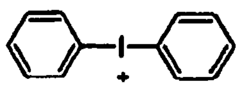 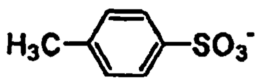

(I-1)

$PF_6^-$ (I-2)

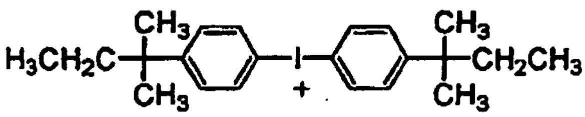

$PF_6^-$ (I-3)

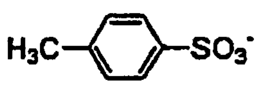

(I-4)

$ClO_4^-$ (I-5)

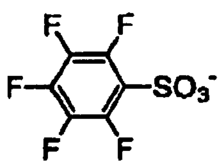

(I-6).

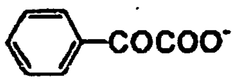 (I-7)

$CF_3SO_3^-$ (I-8)

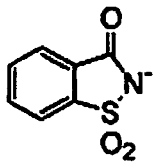 (I-9)

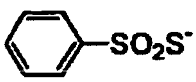 (I-10)

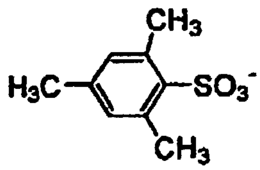 (I-11)

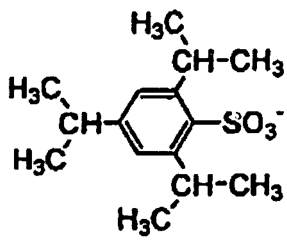 (I-12)

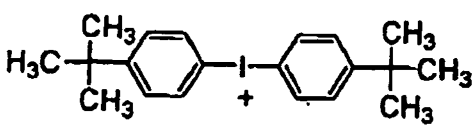 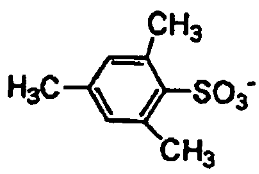 (I-13)

$ClO_4^-$ (I-14)

$PF_6^-$ (I-15)

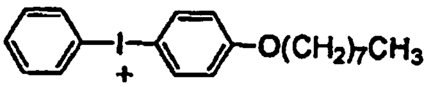 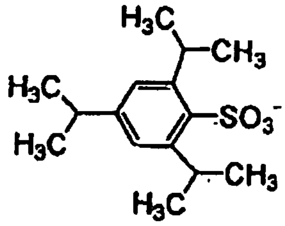 (I-16)

$CF_3COO^-$ (I-17)

$CF_3SO_3^-$ (I-18)

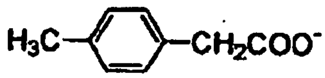 (I-19)

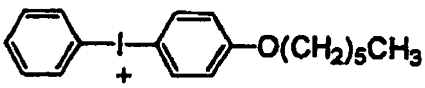 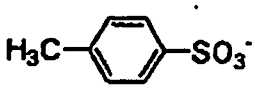 (I-20)

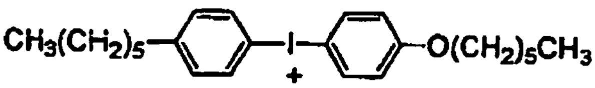 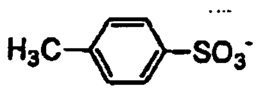 (I-21)

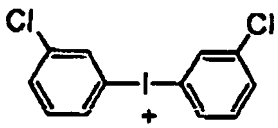

$BF_4^-$ (I-22)

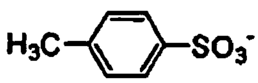 (I-23)

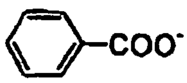 (I-18)

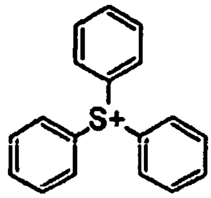

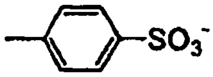 (S-1)

$PF_6^-$ (S-2)

$ClO_4^-$ (S-3)

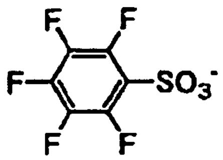 (S-4)

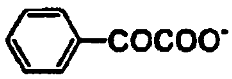 (S-5)

$CF_3SO_3^-$ (S-6)

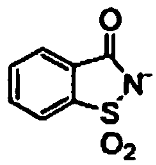 (S-7)

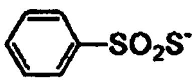 (S-8)

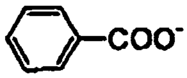

(S-9)

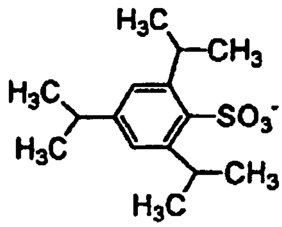

(S-10)

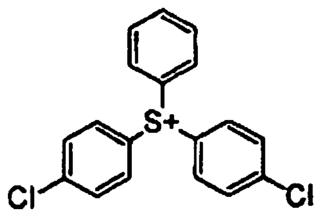

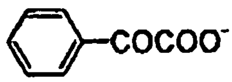

(S-11)

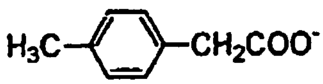

(S-12)

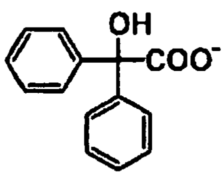

(S-13)

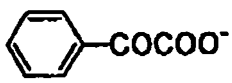

(S-14)

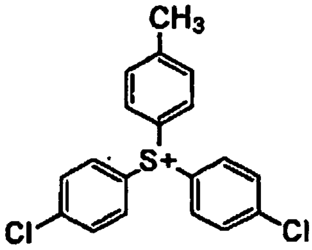

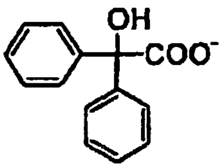

(S-15)

$BF_4^-$ (S-16)

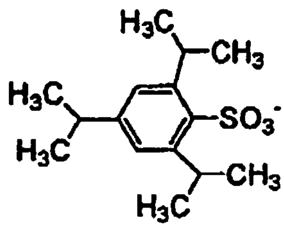

(S-17)

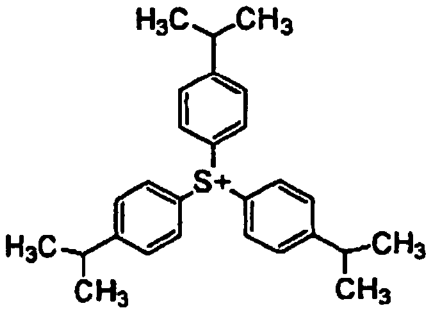

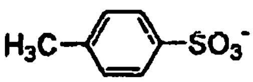

(S-18)

The polymerization initiator is not limited to those described above, but particularly, in view of reactivity and stability, triazine-based initiators, organohalogen compounds, oxime ester compounds, diazonium salts, iodonium salts and sulfonium salts are more preferred.

When a sensitizer is used in combination with the polymerization initiator in the image recording layer of a lithographic printing plate precursor for performing imagewise exposure using a light source of emitting light of 250 to 420 nm, the radical generation efficiency can also be elevated.

Specific examples of the sensitizer include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-tert-butyl-9,10-anthraquinone, 2,6-dichloro-9,10-anthraquinone, xanthone, 2-methylxanthone, 2-methoxyxanthone, thioxanthone, benzyl, dibenzylacetone, p-(dimethylamino)phenyl styryl ketone, p-(dimethylamino)phenyl p-methylstyryl ketone, benzophenone, p-(dimethylamino)benzophenone (or Michler's ketone),

p-(diethylamino)benzophenone and benzanthrone.

Furthermore, preferred examples of the sensitizer for use in the present invention include compounds represented by formula (II) of JP-B-51-48516:

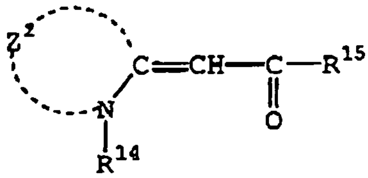

(II)

wherein $R^{14}$ represents an alkyl group (e.g., methyl, ethyl, propyl) or a substituted alkyl group (e.g., 2-hydroxyethyl, 2-methoxyethyl, carboxymethyl, 2-carboxyethyl); $R^{15}$ represents an alkyl group (e.g., methyl, ethyl) or an aryl group (e.g., phenyl, p-hydroxyphenyl, naphthyl, thienyl); and $Z^2$ represents a nonmetallic atom group necessary for forming a nitrogen-containing heterocyclic nucleus usually used in cyanine dyes, for example, benzothiazoles (e.g., benzothiazole, 5-chlorobenzothiazole, 6-chlorothiazole), naphthothiazoles (e.g., α-naphthothiazole, β-naphthothiazole), benzoselenazoles (e.g., benzoselenazole, 5-chlorobenzoselenazole, 6-methoxybenzoselenazole), naphthoselenazoles (e.g., α-naphthoselenazole, β-naphthoselenazole), benzoxazoles (e.g., benzoxazole, 5-methylbenzoxazole, 5-phenylbenzoxazole), naphthoxazoles (e.g., α-naphthoxazole, β-naphthoxazole).

Specific examples of the compound represented by formula (II) include those having a chemical structure constituted by combining these $Z^2$, $R^{14}$ and $R^{15}$. Many of such compounds are present as a known substance and therefore, the compound may be appropriately selected and used from those known substances. Other preferred examples of the sensitizer for use in the present invention include merocyanine dyes described in JP-B-5-47095 and ketocoumarin-based compounds represented by the following formula (III):

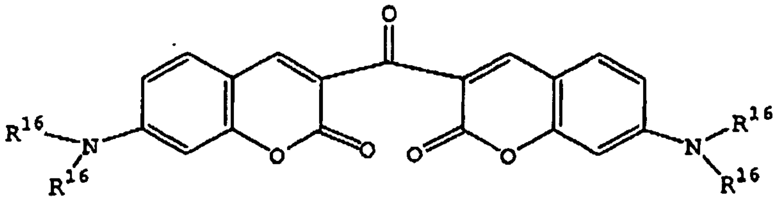

(III)

wherein $R^{16}$ represents an alkyl group such as methyl group and ethyl group.

The sensitizer can be added at a ratio of preferably from 0.1 to 50 wt%, more preferably from 0.5 to 30 wt%, still more preferably from 0.8 to 20 wt%, based on all solid contents constituting the image recording layer.

The polymerization initiator and sensitizer each can be added at a ratio of preferably 0.1 to 50 wt%, more preferably from 0.5 to 30 wt%, still more preferably from 0.8 to 20 wt%, based on all solid contents constituting the image recording layer. Within the range, good sensitivity and good anti-staining property of the non-image part at the printing can be obtained. One of the polymerization initiators may be used alone, or two or more thereof may be used in combination. Also, the polymerization initiator may be added together with other components in the same layer or may be added to a layer separately provided.

<(C) Polymerizable Compound>

The polymerizable compound which can be used in the present invention is an addition-polymerizable compound having at least one ethylenically unsaturated double bond and is selected from compounds having at least one, preferably two or more, ethylenically unsaturated bond(s). Such compounds are widely known in this industrial field and the known compounds can be used in the present invention without any particular limitation.

The compounds have a chemical mode such as monomer, prepolymer (that is, dimer, trimer or oligomer) or a mixture or copolymer thereof. Examples of the monomer include unsaturated carboxylic acids (e.g., acrylic acid, methacrylic acid, itaconic acid, crotonic acid, isocrotonic acid, maleic acid), and esters and amides thereof Among these, preferred are esters of an unsaturated carboxylic acid with an aliphatic polyhydric alcohol compound, and amides of an unsaturated carboxylic acid with an aliphatic polyvalent amine compound. Also, addition reaction products of an unsaturated carboxylic acid ester or amide having a nucleophilic substituent such as hydroxyl group, amino group or mercapto

group with a monofunctional or polyfunctional isocyanate or epoxy, and dehydrating condensation reaction products with a monofunctional or polyfunctional carboxylic acid may be suitably used. Furthermore, addition reaction products of an unsaturated carboxylic acid ester or amide having an electrophilic substituent such as isocyanate group or epoxy group with a monofunctional or polyfunctional alcohol, amine or thiol, and displacement reaction products of an unsaturated carboxylic acid ester or amide having a releasable substituent such as halogen atom or tosyloxy group with a monofunctional or polyfunctional alcohol, amine or thiol may also be suitably used. Also, compounds where the unsaturated carboxylic acid of the above-described compounds is replaced by an unsaturated phosphonic acid, styrene, vinyl ether or the like, may be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomer and isocyanuric acid EO-modified triacrylate.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)-phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate. Examples of the maleic acid ester include ethylene glycol dimaleate, triethylene glycol dimaleate, pentaerythritol dimaleate and sorbitol tetramaleate.

Other examples of the ester include aliphatic alcohol-based esters described in JP-B-51-47334 and JP-A-57-196231, those having an aromatic skeleton described in JP-A-59-5240, JP-A-59-5241 and JP-A-2-226149, and those containing an amino group described in JP-A-1-165613. The ester monomers may also be used as a mixture.

Specific examples of the amide monomer of an aliphatic polyvalent amine compound with an unsaturated carboxylic acid include methylenebisacrylamide, methylene-bismethacrylamide, 1,6-hexamethylenebisacrylamide, 1,6-hexamethylenebismethacrylamide, diethylenetriaminetrisacrylamide, xylylenebisacrylamide and xylylenebismethacrylamide. Other preferred examples of the amide-type monomer include those having a cyclobexylene structure described in JP-B-54-21726.

A urethane-based addition-polymerizable compound produced by using an addition reaction of isocyanate with a hydroxyl group is also preferred and specific examples thereof include vinyl urethane compounds having two or more polymerizable vinyl groups within one molecule described in JP-B-48-41708, which are obtained by adding a vinyl monomer having a hydroxyl group represented by the following formula (IV) to a polyisocyanate compound having two or more isocyanate groups within one molecule:

$$CH_2{=}C(R_4)COOCH_2CH(R_5)OH \qquad (IV)$$

(wherein $R_4$ and $R_5$ each represents H or $CH_3$).

Also, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used. Furthermore, when addition-polymerizable compounds having an amino or sulfide structure in the molecule described in JP-A-63-277653, JP-A-63-260909 and JP-A-1-105238 are used, a photopolymerizable composition having very excellent photo speed can be obtained.

Other examples include polyfunctional acrylates and methacrylates such as polyester acrylates described in JP-A-48-64183, JP-B-49-43191 and JP-B-52-30490 and epoxy acrylates obtained by reacting an epoxy resin with a (meth)acrylic acid. In addition, specific unsaturated compounds described in JP-B-46-43946, JP-B-1-40337 and JP-B-1-40336, and vinyl phosphonic acid-based compounds described in JP-A-2-25493 may be used.

In some cases, structures containing a perfluoroalkyl group described in JP-A-61-22048 are suitably used. Furthermore, those described as a photocurable monomer or oligomer in Nippon Secchaku Kyokaishi, Vol. 20, No. 7, pp. 300-308 (1984) may also be used.

Details of the use method of the addition-polymerizable compound, such as structure, sole or combination use

and amount added, can be appropriately selected in accordance with the designed performance of final lithographic printing plate precursor and, for example, may be selected from the following standpoints.

In view of sensitivity, a structure having a large amount of the unsaturated group content per one molecule is preferred and in most cases, a bifunctional or greater functional compound is preferred. For increasing the strength of image part, namely, cured layer, a trifunctional or greater functional compound is preferred. Also, a method of controlling both sensitivity and strength by using a combination of compounds differing in the functional group number and in the kind of the polymerizable group (for example, an acrylic acid ester, a methacrylic acid ester, a styrene-based compound or a vinyl ether-based compound) is effective.

The selection and use method of the addition-polymerizable compound are important factors also for the compatibility and dispersibility with other components (e.g., binder polymer, initiator, colorant) in the image recording layer. For example, the compatibility may be improved in some cases by using a low purity compound or using two or more compounds in combination. Also, a specific structure may be selected for the purpose of improving the adhesion to the substrate, protective layer described later, or the like.

The polymerizable compound is preferably used in an amount of 5 to 80 wt%, more preferably from 25 to 75 wt%, based on all solid content constituting the image recording layer. Also, the polymerizable compounds may be used individually or in combination of two or more thereof.

Moreover, as for the use method of the polymerizable compound, appropriate structure, formulation and amount added can be appropriately selected by taking account of the degree of polymerization inhibition due to oxygen, resolution, fogging property, change in refractive index, surface tackiness and the like. Depending on the case, a layer structure such as undercoat and overcoat or coating method may also be considered.

<Microcapsule>

In the present invention, the above-described components (A) to (C) constituting the image recording layer and other constituent components described later may be incorporated into the image recording layer by a method of partially enclosing the constituent components in a microcapsule and adding the microcapsule to the image recording layer described, for example, in JP-A-2001-277740 and JP-A-2001-277742. In this case, the constituent components may be incorporated inside and outside the microcapsule at an appropriate ratio.

For microencapsulating the constituent components of the image recording layer, conventionally known methods can be used. Examples of the method for producing a microcapsule include a method utilizing coacervation described in U.S. Patents 2,800,457 and 2,800,458, a method utilizing interfacial polymerization described in U.S. Patent 3,287,154, JP-B-38-19574 and JP-B-42-446, a method utilizing polymer precipitation described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method utilizing monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,07, but the method is not limited thereto..

The microcapsule wall for use in the present invention preferably has a three-dimensionally crosslinked structure and has a property of swelling with a solvent. From this standpoint, the wall material of microcapsule is preferably polyurea, polyurethane, polyester, polycarbonate, polyamide or a mixture thereof, more preferably polyurea or polyurethane. Also, the above-described compound having a crosslinkable functional group such as ethylenically unsaturated bond, which can be introduced into the binder polymer, may be introduced into the microcapsule wall.

The average particle size of the microcapsule is preferably from 0.01 to 3.0 μm, more preferably from 0.05 to 2.0 μm, still more preferably from 0.10 to 1.0 μm. Within the range, good resolution and good aging stability can be obtained.

<Other Components of Image Recording Layer>

The image recording layer of the present invention may further contain various additives, if desired. These are described below.

<Binder Polymer>

The image recording layer of the present invention may contain a binder polymer for enhancing the film strength of the image recording layer. As for the binder polymer, conventionally known binder polymers can be used without limitation, and a polymer having a film forming property is preferred. Examples of such a binder polymer include acrylic

resin, polyvinyl acetal resin, polyurethane resin, polyurea resin, polyimide resin, polyamide resin, epoxy resin, methacrylic resin, polystyrene-based resin, novolak-type phenol-based resin, polyester resin, synthetic rubber and natural rubber.

The binder polymer may have a crosslinking property so as to enhance the film strength in the image part. The crosslinking property may be imparted to the binder polymer by introducing a crosslinkable functional group such as ethylenically unsaturated bond into the main chain or side chain of the polymer. The crosslinkable functional group may be introduced by copolymerization.

Examples of the polymer having an ethylenically unsaturated bond in the main chain of the molecule include poly-1,4-butadiene and poly-1,4-isoprene.

Examples of the polymer having an ethylenically unsaturated bond in the side chain of the molecule include polymers which are a polymer of acrylic or methacrylic acid ester or amide and in which the ester or amide residue (R in -COOR or CONHR) has an ethylenically unsaturated bond.

Examples of the residue (R above) having an ethylenically unsaturated bond include - $(CH_2)_nCR^1=CR^2R^3$, $-(CH_2O)_nCH_2CH^1=CH_2R_3$, $-(CH_2CH_{2O})_nCH_2CR^1=CR^2R^3$, $-(CH_2)_nNH-COO-CH_2CR^1=CR^2R^3$, $-(CH_2)_n-O-CO-CR^1=CR^2R^3$ and $-(CH_2CH_2O)_2-X$ (wherein $R^1$ to $R^3$ each represents a hydrogen atom, a halogen atom or an alkyl, aryl, alkoxy or aryloxy group having 20 or less carbon atoms, $R^1$ and $R^2$ or $R^3$ may combine with each other to form a ring, n represents an integer of 1 to 10, and X represents a dicyclopentadienyl residue).

Specific examples thereof included in the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples thereof included in the amide residue include $-CH_2CH=CH_2$, $-CH_2CH_2-Y$ (wherein Y represents a cyclohexene residue) and $-CH_2CH_2-OCO-CH=CH_2$.

In the binder polymer having a crosslinking property, for example, a free radical (a polymerization initiating radical or a propagating radical in the process of polymerization of a polymerizable compound) is added to the crosslinkable functional group to cause addition-polymerization between polymers directly or through a polymerization chain of the polymerizable compound, as a result, crosslinking is formed between polymer molecules and thereby effecting curing. Alternately, an atom (for example, a hydrogen atom on the carbon atom adjacent to the functional crosslinkable group) in the polymer is withdrawn by a free radical to produce a polymer radical and the polymer radicals combine with each other to form crosslinking between polymer molecules, thereby effecting curing.

The content of the crosslinkable group (content of radical-polymerizable unsaturated double bond determined by iodine titration) in the binder polymer is preferably from 0.1 to 10.0 mmol, more preferably from 1.0 to 7.0 mmol, most preferably from 2.0 to 5.5 mmol, per g of the binder polymer. Within the range, good sensitivity and good storage stability can be obtained.

In the present invention, a hydrophilic binder polymer described below may also be used in addition to the above-described binder polymer. The hydrophilic binder polymer elevates the permeability of the fountain solution into the image recording layer to enhance the on-press developability and is effective, for example, in stabilizing the dispersion of the microcapsule.

Examples of the hydrophilic binder polymer which can be suitably used include those having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, starch derivatives, carboxymethyl cellulose and sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetates having a hydrolysis degree of 60 mol% or more, preferably 80 mol% or more, polyvinyl formal, polyvinyl butyral, polyvinylpyrrolidone, homopolymers and polymers of acrylamide, homopolymers and copolymers of methacrylamide, homopolymers and copolymers of N-methylolacrylamide, polyvinylpyrrolidone, alcohol-soluble nylons, and polyethers of 2,2-bis-(4-hydroxyphenyl)-propane with epichlorohydrin.

The binder polymer preferably has a weight average molecular weight of 5,000 or more, more preferably from 10,000 to 300,000. The number average molecular weight thereof is preferably 1,000 or more, more preferably from 2,000 to 250,000. The polydispersion degree (weight average molecular weight/number average molecular weight) is preferably from 1.1 to 10.

The binder polymer can be synthesized by a conventionally know method. Examples of the solvent used in the synthesis include tetrahydrofuran, ethylene dichloride, cyclohexanone, methyl ethyl ketone, acetone, methanol ethanol, ethylene glycol monomethyl ether, ethylene glycol monoethyl ether, 2-methoxyethyl acetate, diethylene glycol dimethyl

ether, 1-methoxy-2-propanol, 1-methoxy-2-propyl acetate, N,N-dimethylformamide, N,N-dimethylacetamide, toluene, ethyl acetate, methyl lactate, ethyl lactate, dimethylsulfoxide and water. The solvents may be used individually or as a mixture of two or more thereof.

As for the radical polymerization initiator used in the synthesis of the binder polymer, known compounds such as azo-type initiator and peroxide initiator can be used.

The binder polymer content is from 5 to 90 wt%, preferably from 5 to 80 wt%, more preferably from 10 to 70 wt%, based on the entire solid content of the image recording layer. Within the range, good strength of image part and good image-forming property can be obtained.

The polymerizable compound and the binder polymer are preferably used in amounts of giving a weight ratio of 0.5/1 to 4/1.

<Surfactant>

In the present invention, a surfactant is preferably used in the image recording layer so as to accelerate the on-press development at the initiation of printing and improve the coated surface state. The surfactant includes a nonionic surfactant, an anionic surfactant, a cationic surfactant, an amphoteric surfactant, a fluorine-containing surfactant and the like.

The nonionic surfactant for use in the present invention is not particularly limited and a conventionally known nonionic surfactant can be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamines, triethanolamine fatty acid esters, trialkylamine oxides, polyethylene glycol, and copolymers of polyethylene glycol and polypropylene glycoL

The anionic surfactant for use in the present invention is not particularly limited and a conventionally known anionic surfactant can be used. Examples thereof include fatty acid salts, abietates, hydroxyalkanesulfonates, alkanesulfonates, dialkylsulfosuccinic ester salts, linear alkylbenzenesulfbnates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated beef tallow oils, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified products of styrene/maleic anhydride copolymer, partially saponified products of olefin/maleic anhydride copolymer, and naphthalenesulfonate formalin condensates.

The cationic surfactant for use in the present invention is not particularly limited and a conventionally known cationic surfactant can be used. Examples thereof include alkylamine salts, quaternary ammonium salts, polyoxyethylenealkylamine salts and polyethylene polyamine derivatives.

The amphoteric surfactant for use in the present invention is not particularly limited and a conventionally known amphoteric surfactant can be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene and polyoxybutylene, and these surfactants can also be used in the present invention.

The surfactant is more preferably a fluorine-containing surfactant containing a perfluoroalkyl group in the molecule. The fluorine-containing surfactant includes an anionic type such as perfluoroalkylcarboxylate, perfluoroalkylsulfonate and perfluoroalkylphosphoric ester; an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

The surfactants can be used individually or in combination of two or more thereof

The surfactant content is preferably from 0.001 to 10 wt%, more preferably from 0.01 to 7 wt%, based on the entire solid content of the image recording layer.

<Colorant>

In the present invention, various compounds may be further added, if desired, in addition to the above-described additives. For example, a dye having large absorption in the visible region can be used as a colorant of the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI45I70B), Malachite Green (CI42000), Methylene Blue (CI52015), and dyes described in JP-A-62-293247. Also, pigments such as phthalocyanine-based pigment, azo-based pigment, carbon black and titanium oxide may be suitably used.

The colorant is preferably added, because the image part and the non-image part after image formation can be clearly distinguished. The amount of the colorant added is preferably from 0.01 to 10 wt% based on the entire solid content of the image recording material.

<Printing-Out Agent>

In the image recording layer of the present invention, a compound of undergoing change in color under the action of an acid or a radical can be added so as to produce a print-out image. As such a compound, various dyes such as diphenylmethane-based dye, triphenylmethane-based dye, thiazine-based dye, oxazine-based dye, xanthene-based dye, anthraquinone-based dye, iminoquinone-based dye and azomethine-based dye are effective.

Specific examples thereof include dyes such as Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, $\alpha$-Naphthyl Red, Nile Blue 2B, Nile Blue A, Methyl Violet, Malachite Green, Parafuchsine, Victoria Pure Blue BOH [produced by Hodogaya Chemical Co., Ltd.], Oil Blue #603 [produced by Orient Chemical Industry Co., Ltd.], Oil Pink #312 [produced by Orient Chemical Industry Co., Ltd.], Oil Red 5B [produced by Orient Chemical Industry Co., Ltd.], Oil Scarlet #308 [produced by Orient Chemical Industry Co., Ltd.], Oil Red OG [produced by Orient Chemical Industry Co., Ltd.], Oil Red RR [produced by Orient Chemical Industry Co., Ltd.], Oil Green #502 [produced by Orient Chemical Industry Co., Ltd.], Spiron Red BEH Special [produced by Hodogaya Chemical Co., Ltd.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carbostearylamino-4-p-N,N-bis(hydroxyethyl)aminophenyliminonaphthoquinone, 1-phenyl-3-methyl-4-p-diethylaminophenylimino-5-pyrazolone and 1-$\beta$-naphthyl-4-p-dieihylaminophenylimino-5-pyrazolone, and leuco dyes such as p, p',p"-hexamethyltriaminotriphenyl methane (Leuco Crystal Violet) and Pergascript Blue SRB (produced by Ciba Geigy).

Other suitable examples include leuco dyes known as a material for heat-sensitive or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(N,N-dietbylamino)-5-methyl-7-(N,N-dibenzylamino)fluerane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.

The dye of undergoing change in color under the action of an acid or a radical is preferably added in an amount of 0.01 to 15 wt% based on the entire solid content of the image recording layer.

<Polymerization Inhibitor>

In the image recording layer of the present invention, a small amount of a thermopolymerization inhibitor is preferably added so as to prevent the polymerizable compound from undergoing undesirable thermopolymerization during the preparation or storage of the image recording layer.

Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The thermopolymerization inhibitor is preferably added in an amount of about 0.01 to about 5 wt% based on the entire solid content of the image recording layer.

<Higher Fatty Acid Derivative>

In the image recording layer of the present invention, a higher fatty acid derivative such as behenic acid or behenic acid amide may be added to localize on the surface of the image recording layer during drying after coating so as to prevent polymerization inhibition by oxygen. The amount of the higher fatty acid derivative added is preferably from about 0.1 to about 10 wt% based on the entire solid content of the image recording layer.

<Plasticizer>

The image recording layer of the present invention may contain a plasticizer for enhancing the on-press developability.

Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate, glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate.

The plasticizer content is preferably about 30 wt% or less based on the entire solid content of the image recording layer.

<Inorganic Fine Particle>

The image recording layer of the present invention may contain an inorganic fine particle so as to elevate cured film strength in the image part and improve the on-press developability of the non-image part.

Suitable examples of the inorganic fine particle include silica, alumina, magnesium oxide, titanium oxide, magnesium carbonate, calcium alginate and a mixture thereof Even if such an inorganic fine particle has no light-to-heat converting property, it can be used, for example, for strengthening the film or roughening the surface to enhance the adhesion at the interface.

The average particle size of the inorganic fine particle is preferably from 5 nm to 10 μm, more preferably from 0.5 to 3 μm. Within the range, the inorganic particles are stably dispersed in the image recording layer, so that the image recording layer can maintain sufficiently high film strength and the non-image part formed can have excellent hydrophilicity to prevent stain at printing.

Such an inorganic fine particle is easily available on the market as a colloidal silica dispersion or the like.

The inorganic fine particle content is preferably 20 wt% or less, more preferably 10 wt% or less, based on the entire solid content of the image recording layer.

<Low-Molecular Hydrophilic Compound>

The image recording layer of the present invention may contain a hydrophilic low-molecular compound so as to improve the on-press developability. Examples of the hydrophilic low-molecular compound include, as the water-soluble organic compound, glycols and ether or ester derivatives thereof, such as ethylene glycol, diethylene glycol, triethylene glycol, propylene glycol, dipropylene glycol and tripropylene glycol, polyhydroxys such as glycerin and pentaerythritol, organic amines and salts thereof, such as triethanolamine, diethanolamine and monoethanolamine, organic sulfonic acids and salts thereof, such as toluenesulfonic acid and benzenesulfonic acid, organic phosphonic acids and salts thereof, such as phenylphosphonic acid, and organic carboxylic acids and salts thereof, such as tartaric acid, oxalic acid, citric acid, malic acid, lactic acid, gluconic acid and amino acids.

<Formation of Image Recording Layer>

The image recording layer of the present invention is formed by dispersing or dissolving the above-described necessary components in a solvent to prepare a coating solution and coating the coating solution. Examples of the solvent used include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylfonmamide, tetramethylurea, N-methylpyrrolidone, dimethylsulfoxide, sulfolane, γ-butyl lactone, toluene and water, but the solvent is not limited thereto. The solvents are used individually or in combination. The concentration of the solid contents in the coating solution is preferably from 1 to 50 wt%.

The image recording layer of the present invention may also be formed by dispersing or dissolving the same or different components described above in the same or different solvents to prepare a plurality of coating solutions and repeating the coating and drying multiple times.
The coated amount (solid content) of the image recording layer obtained on the support after coating and drying varies depending on the use but, in general, is preferably from 0.3 to 3.0 g/$m^2$. Within the range, good sensitivity and good film properties of the image recording layer can be obtained.
For the coating, various methods may be used and examples thereof include bar coater coating, spin coating, spray coating, curtain coating, dip coating, air knife coating, blade coating and roll coating.

(Support)

The support for use in the lithographic printing plate precursor of the present invention is not particularly limited and may be sufficient if it is a dimensionally stable plate-like material. Examples thereof include paper, paper laminated with plastic (e.g., polyethylene, polypropylene or polystyrene), metal plate (e.g., aluminum, zinc or copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal), and paper or plastic film laminated or vapor-deposited with the above-described metal. Among the supports, a polyester film and an aluminum plate are preferred, and the aluminum plate is more preferred because it is dimensionally stable and relatively inexpensive.
The aluminum plate is a pure aluminum plate, an alloy plate mainly comprising aluminum and containing trace heteroelements, or an aluminum or aluminum alloy thin film laminated with a plastic. Examples of the heteroelement contained in the aluminum alloy include silicon, iron, manganese, copper, magnesium, chromium, zinc, bismuth, nickel and titanium. The heteroelement content in the alloy is preferably 10 wt% or less. In the present invention, a pure aluminum plate is preferred, but completely pure aluminum is difficult to produce in view of refining technique and therefore, an aluminum plate containing trace heteroelements may be used. The aluminum plate is not particularly limited in its composition, and a conventionally known and commonly employed material can be appropriately used.
The thickness of the support is preferably from 0.1 to 0.6 mm, more preferably from 0.15 to 0.4 mm, still more preferably from 0.2 to 0.3 mm.
In advance of using the aluminum plate, the aluminum plate is preferably subjected to a surface treatment such as surface roughening and anodization. The surface treatment facilitates enhancing hydrophilicity and ensuring adhesion between the image recording layer and the support. Before the surface-roughening of aluminum plate, a degreasing treatment for removing the rolling oil on the surface is performed, if desired, by using a surfactant, an organic solvent, an alkaline aqueous solution or the like.
The surface-roughening treatment of the aluminum plate surface is performed by various methods and examples thereof include a mechanical surface-roughening treatment, an electrochemical surface-roughening treatment (surface-roughening treatment of electrochemically dissolving the surface) and a chemical surface-roughening treatment (a surface-roughening treatment of chemically and selectively dissolving the surface).
The mechanical surface-roughening treatment may be performed by using a known method such as ball graining, brush graining, blast graining and buff graining.
The method for the electrochemical surface-roughening treatment includes, for example, a method of passing an alternating or direct current in an electrolytic solution containing an acid such as hydrochloric acid or nitric acid. Also, a method using a mixed acid described in JP-A-54-63902 may be used.
The surface-roughened aluminum plate is, if desired, subjected to an alkali etching treatment using an aqueous solution of potassium hydroxide, sodium hydroxide or the like and after a neutralization treatment, further subjected to an anodization treatment, if desired, so as to enhance the abrasion resistance.
As for the electrolyte for use in the anodization treatment of the aluminum plate, various electrolytes of forming a porous oxide film may be used. Ordinarily, sulfuric acid, hydrochloric acid, oxalic acid, chromic acid or a mixed acid thereof is used. The concentration of the electrolyte is determined appropriately in accordance with the kind of the electrolyte.
The anodization treatment conditions vary depending on the electrolyte used and therefore, cannot be indiscriminately specified, but ordinarily, the conditions are preferably such that the concentration of electrolyte is from 1 to 80 wt%, the liquid temperature is from 5 to 70°C, the current density is from 5 to 60 A/$dm^2$, the voltage is from 1 to 100 V, and the electrolysis time is from 10 seconds to 5 minutes. The amount of the anodic oxide film formed is preferably from 1.0 to 5.0 g/$m^2$, more preferably from 1.5 to 4.0 g/$m^2$. Within the range, good press life and good scratch resistance in the non-image part of the lithographic printing plate can be obtained.
With respect to the support for use in the invention, the substrate having thereon an anodic oxide film after the above-described surface treatment may be used as it is, but in order to more improve adhesion to a layer provided thereon, hydrophilicity, anti-stainicg property, heat insulation and the like, treatments described in JP-A-2001-253181

and JP-A-2001-322365 may be appropriately selected and applied, such as treatment for enlarging micropores of the anodic oxide film, sealing treatment of micopores and surface-hydrophilizing treatment of dipping the substrate in an aqueous solution containing a hydrophilic compound. Of course, the enlarging treatment and sealing treatment are not limited to those described in these patent publications and any conventionally known method may be employed.

As for the sealing treatment, a sealing treatment with steam, a sealing treatment with fluorozirconic acid alone, a sealing treatment with an aqueous solution containing an inorganic fluorine compound, such as treatment with sodium fluoride, a sealing treatment with steam having added thereto lithium chloride, or a sealing treatment with hot water may be employed.

Among these, a sealing treatment with an aqueous solution containing an inorganic fluorine compound, a sealing treatment with water vapor, and a sealing treatment with hot water are preferred. These are described below.

<Sealing Treatment with Aqueous Solution Containing Inorganic Fluorine Compound>

As for the inorganic fluorine compound used in the sealing treatment with an aqueous solution containing an inorganic fluorine compound, a metal fluoride is preferred.

Specific examples thereof include sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluorozirconic acid, fluorotitanic acid, hexafluorosilicic acid, nickel fluoride, iron fluoride, fluorophosphoric acid and ammonium fluorophosphate. Among these, sodium fluorozirconate, sodium fluorotitanate, fluorozirconic acid and fluorotitanic acid are preferred.

The concentration of the inorganic fluorine compound in the aqueous solution is, in view of satisfactory sealing of micropores of the anodic oxide film, preferably 0.01 wt% or more, more preferably 0.05 wt% or more, and in view of anti-staining property, preferably 1 wt% or less, more preferably 0.5 wt% or less.

The aqueous solution containing an inorganic fluorine compound preferably further contains a phosphate compound. When a phosphate compound is contained, the hydrophilicity on the anodic oxide film surface is increased and in turn, the on-press developability and antiscumming property can be improved.

Suitable examples of the phosphate compound include phosphates of an alkali metal, an alkaline earth metal or the like.

Specific examples thereof include zinc phosphate, aluminum phosphate, ammonium phosphate, diammonium hydrogenphosphate, ammonium dihydrogenphosphate, monoammonium phosphate, monopotassium phosphate, monosodium phosphate, potassium dihydrogenphosphate, dipotassium hydrogenphosphate, calcium phosphate, sodium ammonium hydrogenphosphate, magnesium hydrogenphosphate, magnesium phosphate, ferrous phosphate, ferric phosphate, sodium dihydrogenphosphate, sodium phosphate, disodium hydrogenphosphate, lead phosphate, diammonium phosphate, calcium dihydrogenphosphate, lithium phosphate, phosphotungstic acid, ammonium phosphotungstate, sodium phosphotungstate, ammonium phosphomolybdate, sodium phosphomolybdate, sodium phosphite, sodium tripolyphosphate and sodium pyrophosphate. Among these, sodium dihydrogenphosphate, disodium hydrogenphosphate, potassium dihydrogenphosphate and dipotassium hydrogenphosphate are preferred.

The combination of the inorganic fluorine compound and the phosphate compound is not particularly limited, but the aqueous solution preferably contains at least sodium fluorozirconate as the inorganic fluorine compound and at least sodium dihydrogenphosphate as the phosphate compound.

The concentration of the phosphate compound in the aqueous solution is, in view of improvements in the on-press developability and anti-staining property, preferably 0.01 wt% or more, more preferably 0.1 wt% or more, and in view of solubility, preferably 20 wt% or less, more preferably 5 wt% of less.

The ratio of respective compounds in the aqueous solution is not particularly limited, but the weight ratio between the inorganic fluorine compound and the phosphate compound is preferably from 1/200 to 10/1, more preferably from 1/30 to 2/1.

The temperature of the aqueous solution is preferably 20°C or more, more preferably 40°C or more, and preferably 100°C or less, more preferably 80°C or less.

The pH of the aqueous solution is preferably 1 or more, more preferably 2 or more, and preferably 11 or less, more preferably 5 or less.

A method for the sealing treatment with an aqueous solution containing the inorganic fluorine compound is not particularly limited, but examples thereof include a dipping method and a spray method. One of the methods may be used alone once or multiple times, or two or more thereof may be used in combination.

In particular, a dipping method is preferred. In the case of performing the treatment by using a dipping method, the treating time is preferably 1 second or more, more preferably 3 seconds or more, and preferably 100 seconds or less, more preferably 20 seconds or less.

<Sealing Treatment with Water Vapor>

Examples of the sealing treatment with water vapor include a method of continuously or discontinuously bringing water vapor under applied pressure or normal pressure into contact with the anodic oxide film.
The temperature of the water vapor is preferably 80°C or more, more preferably 95°C or more, and preferably 105°C or less.
The pressure of the water vapor is preferably from (atmospheric pressure - 50 mmAq) to (atmospheric pressure + 300 mmAq) (from $1.008\times10^5$ to $1.043\times10^5$ Pa).
The time period for which water vapor is contacted is preferably 1 second or more, more preferably 3 seconds or more, and preferably 100 seconds or less, more preferably 20 seconds or less.

<Sealing Treatment with Hot Water>

Examples of the sealing treatment with hot water include a method of dipping the aluminum plate having formed thereon the anodic oxide film in hot water.
The hot water may contain an inorganic salt (e.g., phosphate) or an organic salt.
The temperature of the hot water is preferably 80°C or more, more preferably 95°C or more, and preferably 100°C or less.
The time period for which the aluminum plate is dipped in hot water is preferably 1 second or more, more preferably 3 seconds or more, and preferably 100 seconds or less, more preferably 20 seconds or less.
As for the hydrophilization treatment, an alkali metal silicate method described in U.S. Patents 2,714,066, 3,181,461, 3,280,734 and 3,902,734 is known. In the method, the support is dipped in an aqueous solution of sodium silicate or the like, or electrolyzed. Other examples include a method of treating the support with potassium fluorozirconate described in JP-B-36-22063, and a method of treating the support with polyvinylphosphonic acid described in U.S. Patents 3,276,868, 4,153,461 and 4,689,272.
In the case of using a support insufficient in the hydrophilicity on the surface, such as a polyester film, for the support of the present invention, a hydrophilic layer is preferably coated to render the surface hydrophilic. Preferred examples of the hydrophilic layer include a layer formed by coating a coating solution containing a colloid of an oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation reaction of polyalkoxysilane, titanate, zirconate or aluminate, and a hydrophilic layer comprising an inorganic thin film having a surface containing a metal oxide. Among these, the hydrophilic layer formed by coating a coating solution containing a colloid of oxide or hydroxide of silicon is more preferred.
In the case of using a polyester film or the like for the support of the present invention, an antistatic layer is preferably provided on the hydrophilic layer side or opposite side of the support or on both sides. When the antistatic layer is provided between the support and the hydrophilic layer, it contributes to the enhancement of adhesion to the hydrophilic layer. Examples of the antistatic layer which can be used include a polymer layer having dispersed therein metal oxide fine particle or matting agent described in JP-A-2002-79772.
The support preferably has a center line average roughness of 0.10 to 1.2 μm. Within the range, good adhesion to the image recording layer, good press life and good anti-staining property can be obtained.
The color density of the support is preferably from 0.15 to 0.65 in terms of the reflection density value. Within the range, good image-forming property by virtue of antihalation at the image exposure and good suitability for plate inspection after development can be obtained.

(Undercoat Layer)

In the lithographic printing plate precursor of the present invention, an undercoat layer comprising a compound having a polymerizable group is preferably provided on the support. When the undercoat layer is used, the image recording layer is provided on the undercoat layer. By virtue of the undercoat layer, in the exposed part, adhesion between the support and the image recording layer is strengthened, whereas in the unexposed part, separation of the image recording layer from the support is facilitated, thereby improving the on-press developability.
Specific suitable examples of the undercoat layer include a silane coupling agent having an addition-polyrneizable ethylenic double bond reactive group described in JP-A-10-282679, and a phosphorus compound having an ethylenic double bond reactive group described in JP-A-2-304441. Also, a compound having a polymerizable group such as methacryl group and allyl group, and a support-adsorbing group such as sulfonic acid group, phosphoric acid group and phosphoric acid ester, and preferably further having a hydrophilicity-imparting group such as ethylene oxide

group is preferably used.

The coated amount (solid content) of the undercoat layer is preferably from 0.1 to 100 mg/$m^2$, more preferably from 1 to 30 mg/$m^2$.

(Backcoat Layer)

After the support is subjected to surface treatment or formation of an undercoat layer, a backcoat layer may be provided on the back surface of the support, if desired.

Preferable examples of the backcoat layer include a coating layer comprising an organic polymer compound described in JP-A-5-45885 or a coating layer comprising a metal oxide obtained by hydrolyzing and polycondensing an organic or inorganic metal compound described in JP-A-6-35174. Among these, those using an alkoxy compound of silicon, such as $Si(OCH_3)_4$, $Si(OC_2H_5)_4$, $Si(OC_3H_7)_4$ and $Si(OC_4H_9)_4$, are preferred because the raw material is inexpensive and easily available.

(Protective Layer)

In the lithographic printing plate precursor of the present invention for use in the lithographic printing method of the present invention, a protective layer may be provided on the image recording layer, if desired, for the purpose of preventing generation of scratches or the like on the image recording layer, blocking oxygen or preventing ablation at the exposure with a high-intensity laser.

In the present invention, the exposure is usually performed in air and the protective layer prevents low molecular compounds such as oxygen and basic substance present in air, which inhibit an image-forming reaction occurring upon exposure in the image recording layer, from penetrating into the image recording layer and thereby prevents the inhibition of image-forming reaction at the exposure in air. Accordingly, the property required of the protective layer is low permeability to low molecular compounds such as oxygen. Furthermore, the protective layer preferably has good transparency to light used for exposure, excellent adhesion to the image recording layer, and easy removability during on-press development after exposure. Various studies have been heretofore made on the protective layer having these properties and such protective layers are described in detail, for example, in U.S. patent 3,458,311 and JP-B-55-49729.

Examples of the material used for the protective layer include water-soluble polymer compounds having relatively excellent crystallinity. Specific examples thereof include water-soluble polymers such as polyvinyl alcohol, polyvinylpyrrolidone, acidic celluloses, gelatin, gum arabic and polyacrylic acid. In particular, when polyvinyl alcohol (PVA) is used as the main component, most excellent results are obtained with respect to basic properties such as oxygen-blocking property and development removability. A part of the polyvinyl alcohol may be replaced by an ester, an ether or an acetal or may have another copolymerization component as long as it contains an unsubstituted vinyl alcohol unit for giving necessary oxygen-blocking property and water solubility to the protective layer.

Examples of the polyvinyl alcohol which can be preferably used include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (for example, selection of PVA and use of additives), coated amount and the like of the protective layer are appropriately selected by taking account of anti-fogging property, adhesion, scratch resistance and the like in addition to the oxygen-blocking property and development removability. Ordinarily, as the PVA has a higher percentage of hydrolysis (namely, as the unsubstituted vinyl alcohol unit content in the protective layer is higher) or as the layer thickness is larger, the oxygen-blocking property is enhanced and this is preferred in view of sensitivity. Also, in order to prevent the generation of undesirable polymerization reaction at the production or during storage or undesirable fogging at the image exposure or prevent thickening or the like of the image line, excessively high oxygen permeability is not preferred. Accordingly, the oxygen permeability A at 25°C and 1 atm is preferably $0.2 \leq A \leq 20$ (cc/$m^2$·day).

As other components of the protective layer, glycerin, dipropylene glycol or the like may be added in an amount corresponding to several wt% based on the polymer compound so as to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether may be added in an amount of several wt% based on the polymer compound.

The adhesion to the image part, scratch resistance and the like of the protective layer are also very important in view of handling of the lithographic printing plate precursor. More specifically, when a protective layer which is hydrophilic by containing a water-soluble polymer compound is formed on the image recording layer which is lipophilic, the protective layer is readily separated due to insufficient adhesive strength and in the separated portion, defects such as curing failure due to polymerization inhibition by oxygen may be caused.

Thus, various proposals have been made in order to improve the adhesive property between the image recording layer and the protective layer. For example, JP-A-49-70702 and BP-A-1,303,578 describe a technique of mixing from 20 to 60 wt% of an acrylic emulsion, a water-insoluble vinylpyrrolidone-vinyl acetate copolymer or the like in a hydrophilic polymer mainly comprising polyvinyl alcohol and coating the solution on the image recording layer, thereby obtaining sufficiently high adhesive property. In the present invention, such known techniques all can be used.
Furthermore, other functions may be imparted to the protective layer. For example, when a colorant (for example, water-soluble dye) excellent in the transparency to light used for exposure and capable of efficiently absorbing light at other wavelengths is added, the aptitude for safelight can be enhanced without causing decrease of sensitivity.
The thickness of the protective layer is suitably from 0.1 to 5 $\mu$m, preferably from 0.2 to 2 $\mu$m.
The method for coating the protective layer is described in detail, for example, in U.S. Patent 3,458,311 and JP-B-55-49729.
The present invention is described in greater detail below by referring to the examples, but the present invention should not be construed as being limited thereto.

1. Production of Lithographic Printing Plate Precursor (1)

(1) Preparation of Support

A 0.3 mm-thick aluminum plate (material: JIS A1050) was degreased with an aqueous 10 wt% sodium aluminate solution at 50°C for 30 seconds to remove the rolling oil on the surface. Thereafter, the aluminum plate surface was grained by using three nylon brushes implanted with bundled bristles having a diameter of 0.3 mm and a water suspension (specific gravity: 1.1 g/cm$^3$) of pumice having a median diameter of 25 $\mu$m, and then thoroughly washed with water. The plate was etched by dipping it in an aqueous 25 wt% sodium hydroxide solution at 45°C for 9 seconds and after washing with water, dipped in 20 wt% nitric acid at 60°C for 20 seconds, followed by washing with water. The etched amount of the grained surface was about 3 g/m$^2$.
Subsequently, the aluminum plate was subjected to a continuous electrochemical surface-roughening treatment by using AC voltage of 60 Hz. The electrolytic solution used was an aqueous 1 wt% nitric acid solution (containing 0.5 wt% of aluminum ion) at a liquid temperature of 50°C. The electrochemical surface-roughening treatment was performed by using an AC power source of giving a rectangular AC having a trapezoidal waveform such that the time TP necessary for the current value to reach the peak from zero was 0.8 msec and the duty ratio was 1:1, and disposing a carbon electrode as the counter electrode. The auxiliary anode was ferrite. The current density was 30 A/dm$^2$ in terms of the peak value of current, and 5% of the current flowing from the power source was split to the auxiliary anode. The quantity of electricity in the nitric acid electrolysis was 175 C/dm$^2$ when the aluminum plate was serving as the anode. Thereafter, the aluminum plate was water-washed by spraying.
Thereafter, the aluminum plate was subjected to an electrochemical surface-roughening treatment in the same manner as in the nitric acid electrolysis above by using, as the electrolytic solution, an aqueous 0.5 wt% hydrochloric acid solution (containing 0.5 wt% of aluminum ion) at a liquid temperature of 50°C under the conditions that the quantity of electricity was 50 C/dm$^2$ when the aluminum plate was serving as the anode, and then water-washed by spraying. The plate was treated in 15% sulfuric acid (containing 0.5 wt% of aluminum ion) as the electrolytic solution at a current density of 15 A/dm$^2$ to provide a DC anodic oxide film of 2.5 g/m$^2$, then washed with water and dried.
Subsequently, the plate was subjected to sealing treatment by dipping it in a solution containing 0.1 wt% of sodium fluorozirconate and I wt% of sodium dihydrogen phosphate at a pH of 3.7 and 75°C for 10 seconds, and further treated in an aqueous 2.5 wt% sodium silicate solution at 30°C for 10 seconds. The center line average roughness (Ra) of the substrate was measured by using a needle having a diameter of 2 $\mu$m and found to be 0.51 $\mu$m.
Furthermore, Undercoat Solution (1) having the following composition was coated to have a dry coated amount of 10 mg/m$^2$, thereby preparing a support for use in tests.

Undercoat Solution (I):

| | |
|---|---|
| Undercoat Compound (1) shown below | 0.017 g |
| Methanol | 9.00 g |
| Water | 1.00 g |

Undercoat Compound (1):

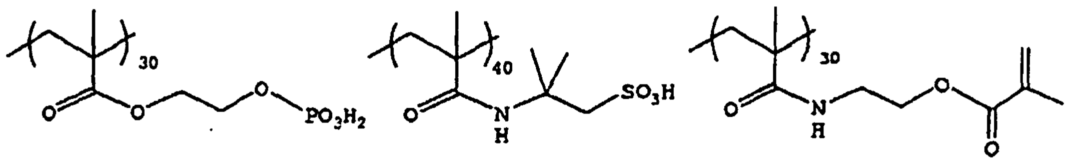

Mw: 30,000

(2) Formation of Image Recording Layer

On the support prepared above, Coating Solution (1) for image recording layer having the following composition was bar-coated and dried in an oven at 100°C for 60 seconds to form an image recording layer having a dry coated amount of 1.0 $g/m^2$, thereby obtaining a lithographic printing plate precursor.

Coating Solution (1) for image recording layer was obtained by mixing and stirring Photosensitive Solution (1) and Microcapsule Solution (1) shown below immediately before coating.

Photosensitive Solution (I):

| | |
|---|---|
| Binder Polymer (1) | 0.162 g |
| Polymerization Initiator (1) shown below | 0.100 g |
| Infrared Absorbing Dye (1) shown below | 0.020 g |
| Polymerizable compound (1) shown below (Aronics M215, produced by Toa Gosei Co., Ltd.) | 0.385 g |
| Fluorine-Containing Surfactant (1) shown below (Megafac F-176, produced Dai-Nippon Ink & Chemicals, Inc.) | 0.044 g |
| Methyl ethyl ketone | 1.091 g |
| 1-Methoxy-2-propanol | 8.609 g |
| Microcapsule Solution (1) | |
| Microcapsule (1) synthesized as follows | 2.640 g |
| Water | 2.425 g |

Binder Polymer (I):

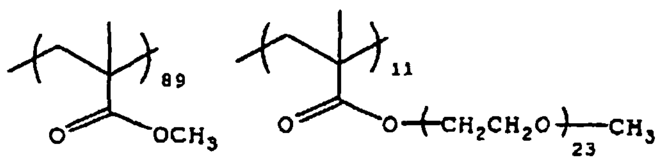

Mw: 120,000

Polymerization Initiator (1):

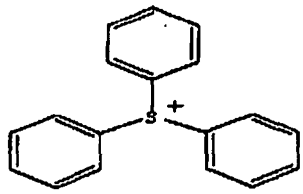

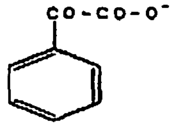

Infrared Absorbent (I):

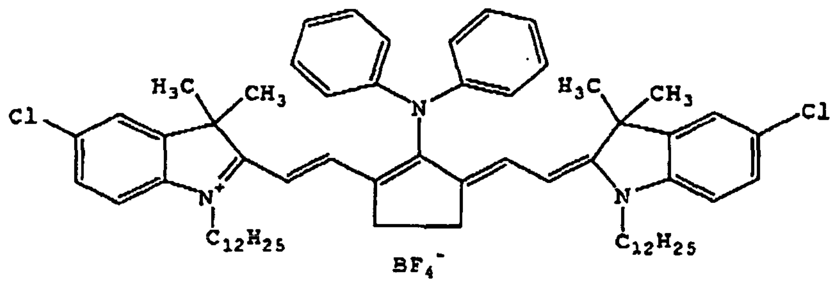

Polymerizable Compound (1)

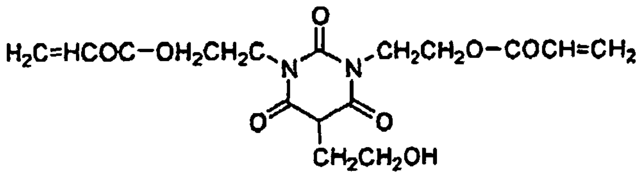

Fluorine-Containing Surfactant (1):

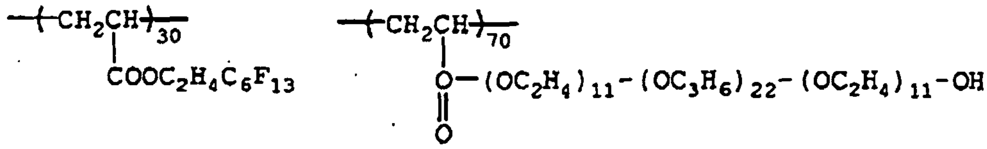

Synthesis of Microcapsule (1):

As the oil phase component, 10 g of trimethylolpropane and xylene diisocyanate adduct (Takenate D-110N, produced by Mitsui Takeda Chemicals, Inc.), 3.15 g of pentaerythritol triacrylate (SR444, produced by Nippon Kayaku Co., Ltd.), 0.35 g of Infrared Absorbent (2) shown below, 1 g of 3-(N,N-diethylamino)-6-methyl-7-anilinofluorane (ODB, produced by Yamamoto Chemicals, Inc.), and 0.1 g of Pionin A-41C (produced by Takemoto Yushi Co., Ltd.) were dissolved in 17 g of ethyl acetate. As the aqueous phase component, 40 g of an aqueous 4 wt% PVA-205 solution was prepared. The oil phase component and the aqueous phase component were mixed and emulsified in a homogenizer at 12,000 rpm for 10 minutes. Thereafter, the resulting emulsified product was added to 25 g of distilled water and the mixture was stirred at room temperature for 30 minutes and then stirred at 40°C for 3 hours. The thus-obtained microcapsule solution was diluted with distilled water to a solid content concentration of 15 wt%. The average particle size was 0.2 μm.

(3) Formation of Protective Layer

A coating solution for protective layer having the following composition was further bar-coated on the image recording layer formed above and then dried in an oven at 125°C for 75 seconds to form a protective layer in a dry coated amount of 0.1 mg/m$^2$, thereby obtaining Lithographic Printing Plate Precursor (1) for use in Examples 1 to 14 and 21 and Comparative

Example 1.

Coating Solution for Protective Layer.

| | |
|---|---|
| Polyvinyl alcohol (Poval PVA105, produced by Kuraray Co., Ltd., saponification degree: 98 to 99 mol%, polymerization degree: 500) | 0.895 g |
| Polyvinylpyrrolidone (K30, produced by Wako Pure Chemical Ind., Ltd., weight average molecular weight: 400,000) | 0.035 g |
| Polyvinylpyrrolidone copolymer (Rubiscol VA64W, produced by BASF Japan Co., weight average molecular weight: 34,000, polyvinylpyrrolidone/vinyl acetate (60/40 by mol) copolymer, 50 wt% aqueous solution) | 0.048 g |
| Nonionic surfactant (Emalex 710, trade name, produced by Nihon Emulsion Co., Ltd.) | 0.020 g |
| Water | 15.200 g |

2. Production of Lithographic Printing Plate Precursor (2)

Lithographic Printing Plate Precursor (2) for use in Examples 15 to 17 was obtained in the same manner as Lithographic Printing Plate Precursor (1) except for changing Coating Solution (1) for image recording layer to Coating Solution (2) for image recording layer having the following composition in the production of Lithographic Printing Plate Precursor (1). Coating Solution (2) for Image Recording Layer:

| | |
|---|---|
| Infrared Absorbent (2) shown below | 0.05 g |
| Polymerization Initiator (2) shown below | 0.20 g |
| Binder Polymer (2) shown below (average molecular weight: 80,000) | 0.50 g |
| Polymerizable compound (1) shown above (Aronics M-215 (produced by Toa Gosei Co., Ltd.) | 1.00 g |
| Naphthalenesulfonate of Victoria Pure Blue | 0.02 g |
| Fluorine-Containing Surfactant (1) shown above | 0.10 g |
| Methyl ethyl ketone | 18.0 g |

Infrared Absorbent (2):

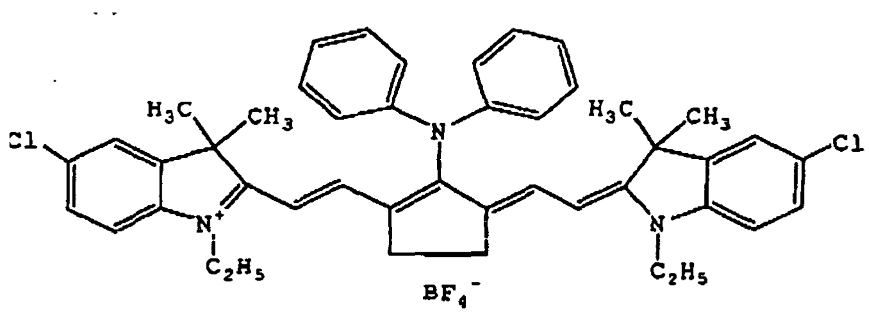

Binder Polymer (2):

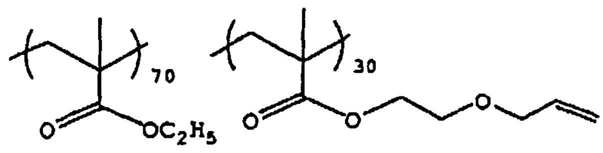

3. Production of Lithographic Printing Plate Precursor (3)

Lithographic Printing Plate Precursor (3) for use in Examples 18 to 20 and 22 was obtained in the same manner as Lithographic Printing Plate Precursor (1) except for changing Coating Solution (1) for image recording layer to Coating Solution (3) for image recording layer having the following composition in the production of Lithographic Printing Plate Precursor (I).

Coating Solution (3) for image recording layer was obtained by mixing Photosensitive Solution (2) and Microcapsule Solution (2) shown below immediately before coating.

Photosensitive Solution (2):

| | |
|---|---|
| Polymerization Initiator (1) | 0.20 g |
| Sensitizer (1) shown below | 1.00 g |
| Binder Polymer (2) (average molecular weight: 80,000 | 3.00 g |
| Polymerizable compound (Aronics M-315, produced by Toa Gosei Co., Ltd.) | 6.20 g |
| Leuco Crystal Violet | 3.00 g |
| Thermal Polymerization Initiator (N-nitroso-phenylhydroxylamine aluminum salt) | 0.10 g |
| Fluorine-Containing Surfactant (1) shown above | 0.10 g |
| Methyl ethyl ketone | 35.00 g |
| 1-Methoxy-2-propanol | 35.00 g |
| Microcapsule Solution (2) | |
| Microcapsule (2) synthesized as follows | 10.00 g |
| Water | 10.00 g |

Sensitizer (I):

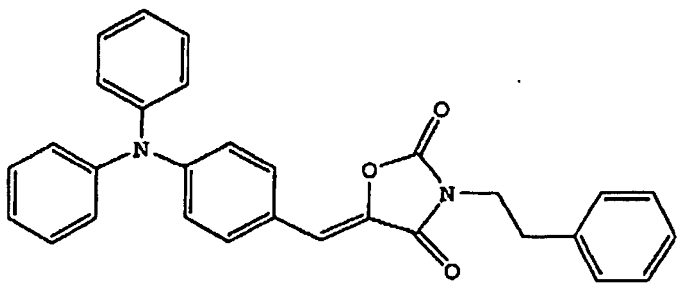

Synthesis of Microcapsule (2):

As the oil phase component, 10 g of trimethylolpropane and xylene diisocyanate adduct (Takenate D-110N, produced by Mitsui Takeda Chemicals, Inc.), 3.15 g of pentaerythritol triacrylate (SR444, produced by Nippon Kayaku Co., Ltd.), 1 g of 3-(N,N-diethylamino)-6-methyl-7-anilinofluorane (ODB, produced by Yamamoto Chemicals, Inc.), and 0.1 g of Pionin A-41C (produced by Takemoto Yushi Co., Ltd.) were dissolved in 17 g of ethyl acetate. As the aqueous phase component, 40 g of an aqueous 4 wt% PVA-205 solution was prepared. The oil phase component and the aqueous phase component were mixed and emulsified in a homogenizer at 12,000 rpm for 10 minutes. Thereafter, the resulting

emulsified product was added to 25 g of distilled water and the mixture was stirred at room temperature for 30 minutes and then stirred at 40°C for 3 hours. The thus-obtained microcapsule solution was diluted with distilled water to a solid content concentration of 20 wt%. The average particle size was 0.25 μm.

4. Lithographic Printing Plate Precursor (4)

Agfa Thermolite (thermal CTP plate having an aluminum base in which an image is formed by heat coalescence of thermoplastic fine particles, produced by Agfa)

Examples 1 to 22 and Comparative Examples to 3

1. Exposure and On-Press Development Using Keyless Inker

Lithographic Printing Plate Precursors (1) and (2) each was exposed in Trendsetter 3244VX (manufactured by Creo) on which a water-cooling 40 W infrared semiconductor laser was mounted, under the conditions such that the output was 9 W, the rotation number of outer drum was 210 rpm and the resolution was 2,400 dpi. The exposure image included a fine line chart.

Also, Lithographic Printing Plate Precursor (3) was exposed with a 375-nm semiconductor laser under the conditions such that the output was 2 mW, the circumferential length of outer drum was 900 mm, the rotation number of drum was 800 rpm and the resolution was 2,400 dpi. The exposure image included a fine line chart.

Lithographic Printing Plate Precursor (4) was exposed in the same manner as Lithographic Printing Plate Precursors (1) and (2) except for changing the output to 17 W and the rotation number of outer drum to 133 rpm.

The exposed plate precursors each was not subjected to a development processing but mounted on a plate cylinder of the printing press shown in Table 1. For the printing press, the printing ink and fountain solution shown in Table 1 were prepared.

Thereafter, on-press development was performed by supplying the ink and, in the case of using a fountain solution, further supplying the fountain solution while rotating the printing press at a rate of 6,000 rotations per hour, and printing of 500 sheets was performed at the timing shown in Table 1.

In the column of timing, "simultaneous" indicates that both on-press development and printing steps were simultaneously operated, and "sequential" indicates that the printing step was operated after the completion of on-press development. As for the printing press, inker, single fluid ink and fountain solution shown in the Table, the contents thereof are described below Table 1.

2. Evaluation

(1) On-Press Developability

The number of rotations of the printing press required until the removal of unexposed part of the image recording layer was completed by the above-described on-press developing method was counted and evaluated as the on-press developability. The evaluation was performed in two regions, that is, a region where an image was not present from gripping head to gripping end of the lithographic printing plate precursor (non-image region), and a region where an image was present (image region). The results are shown in Table 3.

Table 1: Lithographic Printing Plate Precursor Used in Examples and Comparative Examples, and Conditions of On-Press **Development and Printing**

| | Lithographic Printing Plate Precursor | Conditions of On-Press Development and Printing | | | |
|---|---|---|---|---|---|
| | | Printing Press (Inker) | Ink | Fountain Solution | Timing of On-Press Developing Step and Printing Step |
| Example 1 | (1) | keyless (1) | DIC Values-G Black (N) | none | sequential |
| Example 2 | (1) | keyless (2) | DIC Values-G Black (N) | (1) | sequential |

(continued)

| | Lithographic Printing Plate Precursor | Conditions of On-Press Development and Printing | | | |
|---|---|---|---|---|---|
| | | Printing Press (Inker) | Ink | Fountain Solution | Timing of On-Press Developing Step and Printing Step |
| Example 3 | (1) | keyless (2) | DIC Values-G Black (N) | (1) | simultaneous |
| Example 4 | (1) | keyless (2) | DIC Values-G Black (N) | (2) | sequential |
| Example 5 | (1) | keyless (1) | Single Fluid Ink (1) | none | sequential |
| Example 6 | (1) | keyless (1) | Single Fluid Ink (2) | none | sequential |
| Example 7 | (1) | keyless (I) | Single Fluid Ink (3) | none | sequential |
| Example 8 | (1) | keyless (1) | Single Fluid Ink (4) | none | sequential |
| Example 9 | (1) | keyless (1) | Single Fluid Ink (5) | none | sequential |
| Example 10 | (1) | keyless (1) | Single Fluid Ink (6) | none | sequential |
| Example 11 | (1) | keyless (1) | Single Fluid Ink (7) | none | sequential |
| Example 12 | (1) | keyless (1) | Single Fluid Ink (8) | none | sequential |
| Example 13 | (1) | keyless (3) | Single Fluid Ink (1) | none | sequential |
| Example 14 | (1) | keyless (3) | Single Fluid Ink (2) | none | sequential |
| Example 15 | (2) | keyless (2) | DIC Values-G Black (N) | (1) | sequential |
| Example 16 | (2) | keyless (1) | Single Fluid Ink (1) | none | sequential |
| Example 17 | (2) | keyless (3) | Single Fluid Ink (1) | none | sequential |
| Example 18 | (3) | keyless (2) | DIC Values-G Black (N) | (1) | sequential |
| Example 19 | (3) | keyless (1) | Single Fluid Ink (1) | none | sequential |
| Example 20 | (3) | keyless (3) | Single Fluid Ink (1) | none | sequential |
| Example 21 | (1) | conventional | Single Fluid Ink (1) | none | sequential |
| Example 22 | (3) | conventional | Single Fluid Ink (1) | none | sequential |

(continued)

| | Lithographic Printing Plate Precursor | Conditions of On-Press Development and Printing | | | |
|---|---|---|---|---|---|
| | | Printing Press (Inker) | Ink | Fountain Solution | Timing of On-Press Developing Step and Printing Step |
| Comparative Example 1 | (1) | conventional | DIC Values-G Black (N) | (I) | sequential |
| Comparative Example 2 | (4) | conventional | Single Fluid Ink (I) | none | sequential |
| Comparative Example 3 | (4) | conventional | DIC Values-G Black (N) | (1) | sequential |

<Printing Press (Inker)>

Keyless (1):
The printing apparatus 20 (keyless inker) shown in Fig. 1.
Keyless (2):
The printing apparatus (keyless inker) shown in Fig. 2 of JP-A-58-84771.
Keyless (3):
Eco-Grapher (keyless inker) manufactured by Hamada Printing Press Co., Ltd.
Conventional:
SOR-M Printing Press (conventional inker) manufactured by Heidelberg.

<Preparation of Single Fluid Ink (1)>

Varnishes A to C each having the following composition were prepared and using the varnishes, the oily ink component of (2) below was prepared. Also, the hydrophilic component of (3) was prepared.

Thereafter, 100 parts by weight of the oily ink component of (2) and 70 parts by weight of the hydrophilic component of (3) were mixed with stirring to prepare W/O Type Single Fluid Ink (1).

(1) Preparation of Varnish (in the following, the "parts" means "parts by weight")

| | | |
|---|---|---|
| Varnish A: | Maleated petroleum resin (Neopolymer 120, produced by Nippon Oil Corp.) | 47 parts |
| | Spindle oil | 53 parts |
| Gel Varnish B: | Rosin-modified phenolic resin (Tamanol 354, produced by Arakawa Chemical Industries, Ltd.) | 34 parts |
| | Machine oil | 31 parts |
| | Spindle oil | 31 parts |
| | Aluminum stearate | 4 parts |
| Varnish C: | Gilsonite | 25 parts |
| | Machine oil | 75 parts |

(2) Preparation of Oily Ink Component

| | |
|---|---|
| Carbon black | 14 parts |
| Calcium carbonate (Hakuenka DD, produced by Shiraishi Kogyo) | 5 parts |
| Varnish A | 27 parts |
| Gel Varnish B | 7 parts |
| Varnish C | 11 parts |

(continued)

| | |
|---|---|
| (2) Preparation of Oily Ink Component | |
| Linseed oil | 4 parts |
| Machine oil | 6 parts |
| Spindle oil | 24 parts |
| Cyanine Blue | 1 part |
| (3) Preparation of Hydrophilic Component: | |
| Purified water | 10 parts |
| Propylene glycol | 55 parts |
| Glycerin | 34 parts |
| Surfactant (polyoxyethylene alkylphenyl ether, Liponox NCE, produced by The Lion Fat & Oil Co., Ltd.) | I part |

<Preparation of Single Fluid Ink (2)>

The following (1) varnish, (2) oily ink component and (3) hydrophilic component were prepared. Thereafter, 100 parts by weight of the oily ink component of (2) and 45 parts by weight of the hydrophilic component of (3) were mixed with stirring to prepare W/O Type Single Fluid Ink (2).

| | |
|---|---|
| (1) Preparation of Varnish (in the following, the "parts" means "parts by weight") | |
| Rosin-modified phenolic resin (Hitanol 270T, produced by Hitachi Chemical Co., Ltd. | 42 parts |
| Low-viscosity polymerized linseed oil varnish (2 poises) | 30 parts |
| Spindle oil | 27 parts |
| Ethylacetacetoaluminum diisopropylate | 1 part |

| | |
|---|---|
| (2) Preparation of Oily Ink Component: | |
| Gel Varnish D | 66 parts |
| Phthalocyanine Blue | 20 parts |
| Low-viscosity polymerized linseed oil varnish (2 poises) | 5 parts |
| Polyethylene wax compound | 3 parts |
| Cobalt dryer | 1 part |
| Spindle oil | 5 parts |
| (3) Preparation of Hydrophilic Component: | |
| Ethylene glycol | 100 parts |

<Preparation of Single Fluid Inks (3) to (8)>

Single Fluid Inks (3) to (8) were prepared in the same manner as Single Fluid Ink (2) except for changing the hydrophilic component of Single Fluid Ink (2) to the composition shown in Table 2 below.

Table 2: Hydrophilic Component of Single Fluid Inks (3) to (8)

| | Hydrophilic Component |
|---|---|
| Single Fluid Ink (3) | ethylene glycol/dipropylene glycol/glycerin (40/10/30) |
| Single Fluid Ink (4) | ethylene glycol/diethylene glycol (50/50) |
| Single Fluid Ink (5) | ethylene glycol/glycerin/water (45/20/35) |
| Single Fluid Ink (6) | ethylene glycol/water/diethanolamine (50/45/5) |
| Single Fluid Ink (7) | ethylene glycol/water/polyvinylpyrrolidone (80/15/5) |
| Single Fluid Ink (8) | ethylene glycol/glycerin/water/sodium hexametaphosphate/citric acid (45/20/25/5/5) |

<Composition of Fountain Solution (1)>

**EU-3 (produced by Fuji Photo Film Co., Ltd.)/water/ isopropyl alcohol = 1/89/10 (by volume)**

volume)

<Composition of Fountain Solution (2)>

**IF-102 (produced by Fuji Photo Film Co., Ltd.)/water = 2/98 (by volume)**

Table 3: Evaluation Results of On-Press Developability

| | On-Press Developability [number of rotations] | |
|---|---|---|
| | Image Region | Non-Image Region |
| Example 1 | 50 | 50 |
| Example 2 | 35 | 35 |
| Example 3 | 25 | 25 |
| Example 4 | 30 | 30 |
| Example 5 | 25 | 25 |
| Example 6 | 25 | 25 |
| Example 7 | 25 | 25 |
| Example 8 | 25 | 25 |
| Example 9 | 25 | 25 |
| Example 10 | 20 | 20 |
| Example 11 | 25 | 25 |
| Example 12 | 20 | 20 |
| Example 13 | 25 | 25 |
| Example 14 | 25 | 25 |
| Example 15 | 40 | 40 |
| Example 16 | 30 | 30 |
| Example 17 | 30 | 30 |
| Example 18 | 35 | 35 |
| Example 19 | 25 | 25 |
| Example 20 | 25 | 25 |
| Example 21 | 30 | 30 |
| Example 22 | 30 | 30 |
| Comparative Example 1 | 35 | 200 |

(continued)

| | On-Press Developability [number of rotations] | |
|---|---|---|
| | Image Region | Non-Image Region |
| Comparative Example 2 | 100 | 120 |
| Comparative Example 3 | 80 | 100 |

As apparent from Table 3, according to the lithographic printing method (Examples 1 to 20 using the keyless inker and Examples 21 to 22 using the single fluid ink) of the present invention, the delay of on-press development in the non-image region is remarkably improved as compared with the conventional lithographic printing method (Comparative Examples I to 3) using a conventional inker, and the on-press developability is very excellent in the plane uniformity within the lithographic printing plate precursor.

## Claims

**1.** A lithographic printing method comprising the following steps (i) to (v):

(i) a step of preparing a lithographic printing plate precursor comprising a support having thereon an image recording layer removable by a printing ink, a fountain solution or both thereof,
(iia) a step of loading the lithographic printing plate precursor on a plate cylinder of a printing press after imagewise exposing it, or (iib) a step of imagewise exposing the lithographic printing plate precursor after loading it on a plate cylinder of a printing press,
(iii) a step of supplying ink to the lithographic printing plate precursor after exposure by a keyless inker, the keyless inker comprising an ink metering part having an ink draw roller, an ink applying roller and a rotation control part to control rotation of the ink draw roller and the ink applying roller,
(iv) a step of removing the image recording layer of the lithographic printing plate precursor in the unexposed part after the completion of the step (iii) or simultaneously with the step (iii), and
(v) a step of performing printing.

**2.** The lithographic printing method as claimed in Claim 1, which further comprises, in any one of the steps (iii) to (v), a step of supplying a fountain solution to the lithographic printing plate precursor after exposure.

**3.** The lithographic printing method as claimed in Claim 1, wherein the ink supplied to the lithographic printing plate precursor after exposure in the step (iii) is single fluid ink.

**4.** The lithographic printing method as claimed in Claim 1 or Claim 2, wherein the image recording layer contains (A) an infrared absorbent, (B) a polymerization initiator and (C) a polymerizable compound, and a light source for the imagewise exposure is an infrared laser.

**5.** The lithographic printing method as claimed in Claim 1 or Claim 2, wherein the image recording layer contains (B) a polymerization initiator and (C) a polymerizable compound and is sensitive to light of a wavelength of 250 to 420 nm, and a light source for the imagewise exposure is an ultraviolet laser.

**6.** A lithographic printing method comprising the following steps (i) to (v): ,

(i) a step of preparing a lithographic printing plate precursor comprising a support having thereon an image recording layer capable of being removed by a printing ink, a fountain solution or both thereof and forming an image by polymerization of a polymerizable compound,
(iia) a step of loading the lithographic printing plate precursor on a plate cylinder of a printing press after imagewise exposing it, or (iib) a step of imagewise exposing the lithographic printing plate precursor after loading it on a plate cylinder of a printing press,
(iii) a step of supplying to the lithographic printing plate precursor after exposure, a single fluid ink comprising an emulsion comprising a hydrophilic component comprising water and/or a polyhydric alcohol and an oily ink component, said single fluid ink being supplied using a keyless inker comprising an ink metering part having an ink draw roller, an ink applying roller and a rotation control part to control rotation of the ink draw roller and

the ink applying roller,
(iv) a step of removing the image recording layer of the lithographic printing plate precursor in the unexposed part after the completion of the step (iii) or simultaneously with the step (iii), and
(v) a step of performing printing.

**7.** The lithographic printing method as claimed in Claim 6, wherein in the single fluid ink supplied in the step (iii), a ratio between the oily ink component and the hydrophilic component is such that the hydrophilic component is from 5 to 150 parts by weight per 100 parts by weight of the oily ink component.

**8.** The lithographic printing method as claimed in Claim 6 or Claim 7, wherein the image recording layer contains (A) an infrared absorbent, (B) a polymerization initiator and (C) a polymerizable compound, and a light source for the imagewise exposure is an infrared laser.

**9.** The lithographic printing method as claimed in Claim 6 or Claim 7, wherein the image recording layer contains (B) a polymerization initiator and (C) a polymerizable compound and is sensitive to light at a wavelength of 250 to 420 nm, and a light source for the imagewise exposure is an ultraviolet laser.

**Patentansprüche**

**1.** Lithographie-Druckverfahren umfassend die folgenden Schritte (i) bis (v):

(i) einen Schritt des Herstellens eines Lithographie-Druckplattenvorläufers umfassend einen Träger mit einer Bildaufzeichnungsschicht darauf, die durch eine Drucktinte, eine Feuchtlösung oder beides entfernbar ist,
(iia) einen Schritt des Setzens des Lithographie-Druckplattenvorläufers auf einen Plattenzylinder einer Druckmaschine nach dessen bildweisem Belichten oder
(iib) einen Schritt des bildweisen Belichtens des Lithographie-Druckplattenvorläufers, nachdem er auf einen Plattenzylinder einer Druckmaschine gesetzt worden ist,
(iii) einen Schritt des Zuführens von Tinte zu dem Lithographie-Druckplattenvorläufer nach dem Belichten durch einen typenlosen Inker, wobei der letterlose Inker eine Tintendosiervorrichtung mit einer Tintenvorzugswalze, einer Tintenauftragungswalze und einer Rotationssteuereinrichtung umfaßt, um die Rotation der Tintenvorzugswalze und der Tintenauftragungswalze zu steuern,
(iv) einen Schritt des Entfernens der Bildaufzeichnungsschicht des Lithographie-Druckplattenvorläufers in dem nicht belichteten Bereich nach Abschluß des Schritts (iii) oder gleichzeitig mit Schritt (iii) und
(v) einen Schritt des Durchführens eines Drucks.

**2.** Lithographie-Druckverfahren gemäß Anspruch 1, das ferner in einem der Schritte (iii) bis (v) einen Schritt des Zuführens einer Feuchtlösung zu dem Lithographie-Druckplattenvorläufer nach Belichtung umfaßt.

**3.** Lithographie-Druckverfahren gemäß Anspruch 1, wobei die dem Lithographie-Druckplattenvorläufer nach Belichtung im Schritt (iii) zugeführte Tinte eine Einfluidtinte ist.

**4.** Lithographie-Druckverfahren gemäß Anspruch 1 oder 2, wobei die Bildaufzeichnungsschicht (A) einen Infrarotabsorber, (B) einen Polymerisationsstarter und (C) eine polymerisierbare Verbindung enthält und die Lichtquelle für die bildweise Belichtung ein Infrarotlaser ist.

**5.** Lithographie-Druckverfahren gemäß Anspruch 1 oder 2, wobei die Bildaufzeichnungsschicht (B) einen Polymerisationsstarter und (C) eine polymerisierbare Verbindung enthält und für Licht einer Wellenlänge von 250 bis 420 nm empfindlich ist und die Lichtquelle für die bildweise Belichtung ein Ultraviolettlaser ist.

**6.** Lithographie-Druckverfahren umfassend die folgenden Schritte (i) bis (v):

(i) einen Schritt des Herstellens eines Lithographie-Druckplattenvorläufers umfassend einen Träger mit einer Bildaufzeichnungsschicht darauf, die in der Lage ist, durch eine Drucktinte, eine Feuchtlösung oder beides entfernt zu werden und ein Bild durch Polymerisation einer polymerisierbaren Verbindung zu bilden,
(iia) einen Schritt des Setzens des Lithographie-Druckplattenvorläufers auf einen Plattenzylinder einer Druckmaschine nach dessen bildweisem Belichten oder
(iib) einen Schritt des bildweisen Belichtens des Lithographie-Druckplattenvorläufers, nachdem er auf einen

Plattenzylinder einer Druckmaschine gesetzt worden ist,
(iii) einen Schritt des Zuführens einer Einfluidtinte umfassend eine Emulsion umfassend eine hydrophile Komponente umfassend Wasser und/oder einen mehrbasigen Alkohol und eine ölige Tintenkomponente zu dem Lithographie-Druckplattenvorläufer nach dem Belichten, wobei die Einfluidtinte unter Verwendung eines typenlosen Inkers umfassend eine Tintendosiervorrichtung mit einer Tintenvorzugswalze, einer Tintenauftragungswalze und einer Rotationssteuereinrichtung, um die Rotation der Tintenvorzugswalze und der Tintenauftragungswalze zu steuern, zugeführt wird,
(iv) einen Schritt des Entfernens der Bildaufzeichnungsschicht des Lithographie-Druckplattenvorläufers in dem nicht belichteten Bereich nach Abschluß des Schritts (iii) oder gleichzeitig mit Schritt (iii) und
(v) einen Schritt des Durchführens eines Drucks.

7. Lithographie-Druckverfahren gemäß Anspruch 6, wobei in der in Schritt (iii) zugeführten Einfluidtinte das Verhältnis zwischen der öligen Tintenkomponente und der hydrophilen Komponente so ist, daß die hydrophile Komponente 5 bis 150 Gew.Teile pro 100 Gew.Teilen der öligen Tintenkomponente ausmacht.

8. Lithographie-Druckverfahren gemäß Anspruch 6 oder 7, wobei die Bildaufzeichnungsschicht (A) einen Infrarotabsorber, (B) einen Polymerisationsstarter und (C) eine polymerisierbare Verbindung enthält und die Lichtquelle für die bildweise Belichtung ein Infrarotlaser ist.

9. Lithographie-Druckverfahren gemäß Anspruch 6 oder 7, wobei die Bildaufzeichnungsschicht (B) einen Polymerisationsstarter und (C) eine polymerisierbare Verbindung enthält und für Licht bei einer Wellenlänge von 250 bis 420 nm empfindlich ist und die Lichtquelle für die bildweise Belichtung ein Ultraviolettlaser ist.

## Revendications

1. Procédé d'impression lithographique comprenant les étapes (i) à (v) suivantes :

(i) une étape de préparation d'un précurseur de plaque d'impression lithographique, comprenant un support présentant une couche d'enregistrement d'image, pouvant être enlevée par une encre d'impression, une solution de mouillage ou les deux,
(iia) une étape de charge du précurseur de plaque d'impression lithographique sur un cylindre de plaque d'une presse d'impression après exposition de celle-ci pour former une image, ou (iib) une étape d'exposition pour former une image du précurseur de plaque d'impression lithographique après charge de celui-ci sur un cylindre de plaque d'une presse d'impression,
(iii) une étape d'apport d'encre au précurseur de plaque d'impression lithographique après exposition par un encreur sans vis, l'encreur sans vis comprenant une pièce de mesure d'encre ayant un rouleau toucheur-encreur, un rouleau d'application de l'encre et une pièce du contrôle de la rotation pour contrôler la rotation du rouleau toucheur-encreur et du rouleau d'application de l'encre,
(iv) une étape d'élimination de la couche d'enregistrement d'image du précurseur de plaque d'impression lithographique dans la zone non exposée après l'achèvement de l'étape (iii) ou simultanément à l'étape (iii), et
(v) une étape de réalisation de l'impression.

2. Procédé d'impression lithographique selon la revendication 1, qui comprend en outre, dans l'une quelconque des étapes (iii) à (v), un étape d'apport d'une solution de mouillage au précurseur de plaque d'impression lithographique après exposition.

3. Procédé d'impression lithographique selon la revendication 1, dans lequel l'encre fournie au précurseur de plaque d'impression lithographique après exposition à l'étape (iii) est une encre fluide unique.

4. Procédé d'impression lithographique selon la revendication 1 ou 2, dans lequel la couche d'enregistrement d'image contient (A) un absorbant infrarouge, (B) un initiateur de la polymérisation, et (C) un composé polymérisable, et une source de lumière pour l'exposition pour former une image est un laser infrarouge.

5. Procédé d'impression lithographique selon la revendication 1 ou 2, dans lequel la couche d'enregistrement d'image contient (B) un initiateur de la polymérisation, et (C) un composé polymérisable, et est sensible à une lumière ayant une longueur d'onde allant de 250 à 420 nm, et une source de lumière pour l'exposition pour former une image est un laser ultraviolet.

6. Procédé d'impression lithographique comprenant les étapes (i) à (v) suivantes :

(i) une étape de préparation d'un précurseur de plaque d'impression lithographique, comprenant un support présentant une couche d'enregistrement d'image, pouvant être enlevée par une encre d'impression, une solution de mouillage ou les deux, et de formation d'une image par polymérisation d'un composé polymérisable,
(iia) une étape de charge du précurseur de plaque d'impression lithographique sur un cylindre de plaque d'une presse d'impression après exposition de celle-ci pour former une image, ou (iib) une étape d'exposition pour former une image du précurseur de plaque d'impression lithographique après charge de celui-ci sur un cylindre de plaque d'une presse d'impression,
(iii) une étape d'apport au précurseur de plaque d'impression lithographique, d'une encre fluide unique comprenant une émulsion, comprenant un composant hydrophile comprenant de l'eau et/ou un alcool polyhydroxylé et un composant d'encre huileux, ladite encre fluide unique étant alimentée à l'aide d'un encreur sans vis comprenant une pièce de mesure d'encre ayant un rouleau toucheur-encreur, un rouleau d'application de l'encre et une pièce du contrôle de la rotation pour contrôler la rotation du rouleau toucheur-encreur et du rouleau d'application de l'encre,
(iv) une étape d'élimination de la couche d'enregistrement d'image du précurseur de plaque d'impression lithographique dans la zone non exposée après l'achèvement de l'étape (iii) ou simultanément à l'étape (iii), et
(v) une étape de réalisation de l'impression.

7. Procédé d'impression lithographique selon la revendication 6, dans lequel dans l'encre fluide unique alimentée dans l'étape (iii), le rapport entre le composant d'encre huileux et le composant hydrophile est tel que le composant hydrophile constitué 5 à 150 parties en poids par 100 parties en poids du composant d'encre huileux.

8. Procédé d'impression lithographique selon la revendication 6 ou 7, dans lequel la couche d'enregistrement d'image (A) contient un absorbant infrarouge, (B) un initiateur de la polymérisation et (C) un composé polymérisable et une source de lumière pour l'exposition formant image est une lumière infrarouge.

9. Procédé d'impression lithographique selon la revendication 6 ou 7, dans lequel la couche d'enregistrement d'image contient (B) un initiateur de la polymérisation, et (C) un composé polymérisable, et est sensible à une lumière ayant une longueur d'onde allant de 250 à 420 nm, et une source de lumière pour l'exposition pour former une image est un laser ultraviolet.

FIG. 1

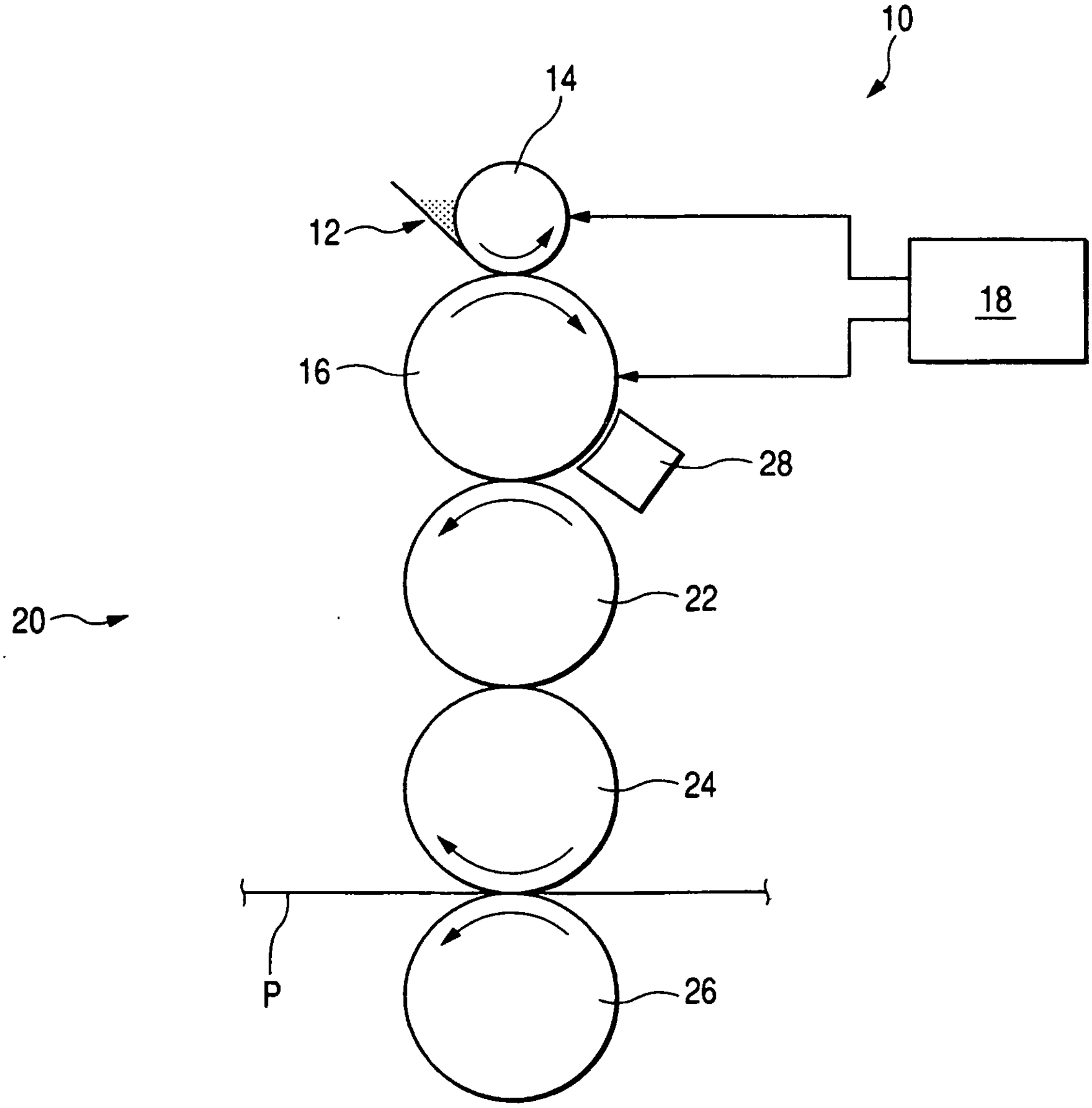

FIG. 2(A)

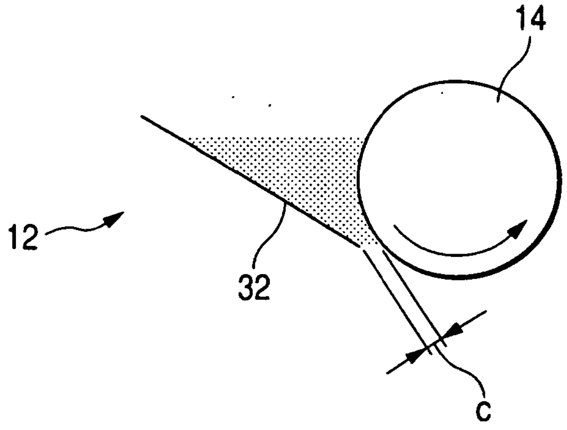


FIG. 2(B)

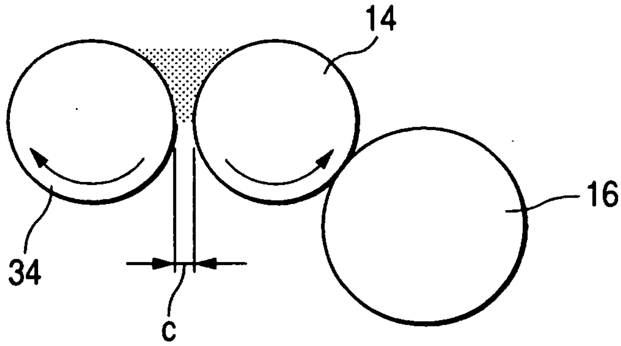


FIG. 2(C)

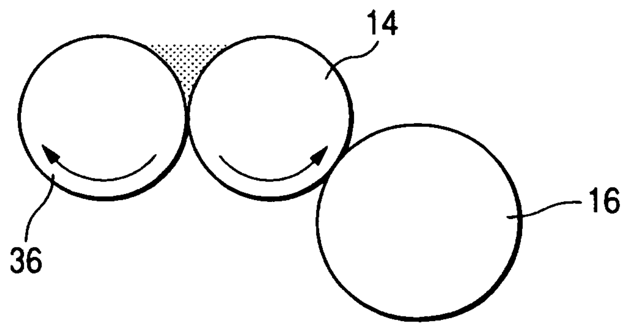

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2938397 B
- JP 2001277740 A
- JP 2002029162 A
- WO 9305446 A
- WO 9634316 A
- JP 2002321331 A
- JP 2003225991 A
- JP 58045955 A
- JP 58065663 A
- JP 58084771 A
- JP 61280938 A
- JP 63162244 A
- JP 53036308 A
- JP 49026844 B
- JP 49027124 B
- JP 49027125 B
- JP 61052867 B
- JP 53027803 A
- JP 53029807 A
- JP 53036307 A
- JP 54106305 A
- JP 54146110 A
- JP 57212274 A
- JP 58037069 A
- JP 58211484 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2002278057 A
- JP 2001133969 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A

- JP 7306527 A
- JP 7292014 A
- JP 61166544 A
- JP 2003328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 51048516 B
- JP 5047095 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 A
- GB 930422 A
- US 3111407 A
- GB 952807 A
- GB 96707 A
- JP 7021633 B
- JP 62170950 A
- JP 62226143 A
- JP 60168144 A
- JP 62293247 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 5045885 A
- JP 6035174 A
- US 3458311 A
- JP 55049729 B
- JP 49070702 A

**Non-patent literature cited in the description**

- **YUKI GOSEI KAGAKU KYOKAI.** *Senryo Binran,* 1970
- **NIPPON GANRYO GIJUTSU KYOKAI.** *Color Index (C.I.), Saishin Ganryo Binran,* 1977

- Saishin Ganryo Oyo Gijutsu. CMC Shuppan, 1986
- Insatsu Ink Gijutsu. CMC Shuppan, 1984
- Kinzoku Sekken no Seishitsu to Oyo. Saiwai Shobo
- Saishin Gamyo Oyo Gijutsu. CMC Shuppan, 1986
- **WAKABAYASHI et al.** *Bull. Chem. Soc. Japan,* 1969, vol. 42, 2924
- **M.P. HUTT.** *Journal of Heterocyclic Chemistry,* 1970, vol. 1 (3
- **MARTIN KUNZ.** *Rad Tech. '98. Proceeding,* 19 April 1998
- *J.C.S. Perkin* Π*,* 1979, 1653-1660
- *J.C.S. Perkin II,* 1979, 156-162
- *Journal of Photopolymer Science and Technology,* 1995, 202-232
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J Polymer Sci., Polymer Chem. Ed.,* 1979, vol. 17, 1047
- **C.S. WEN et al.** *Teh. Proc Coni Rad. Curing ASIA,* October 1988, 478
- *Nippon Secchaku Kyokaishi,* 1984, vol. 20 (7), 300-308